# EUROPEAN PATENT APPLICATION

(11) **EP 4 692 576 A1**
(43) Date of publication of application: **11.02.2026**
(21) Application number: 24864171.4
(22) Date of filing: 20.06.2024
(51) Int. Cl.: F16C 11/04

(54) **ROTATING SHAFT MECHANISM AND ELECTRONIC DEVICE**

(30) Priority: 14.09.2023 CN 202311191742
(71) Applicant: Huawei Technologies Co., Ltd., Shenzhen, Guangdong 518129 (CN)
(72) Inventor: LIN, Yangming, Shenzhen, Guangdong 518129 (CN); WANG, Song, Shenzhen, Guangdong 518129 (CN); NI, Yu, Shenzhen, Guangdong 518129 (CN); QIU, Jiahuan, Shenzhen, Guangdong 518129 (CN)
(74) Representative: Grünecker Patent- und Rechtsanwälte PartG mbB
(86) International application number: PCT/CN2024/100373
(87) International publication number: WO 2025/055446

(57) **Abstract**

A hinge mechanism (100) and an electronic device (200) are provided. The hinge mechanism is configured to connect a first component (E) and a second component (F). The first component (E) is rotatably connected to the second component (F) about a first axis (Q1). The hinge mechanism (100) includes a first damping structure (1), a second damping structure (2), and a connecting piece (3). The first damping structure (1) is mounted on the first component (E). The first damping structure (1) and the second damping structure (2) are spaced apart in a first direction (X) and are connected through the connecting piece (3). The first damping structure (1) rotates about the first axis (Q1) relative to the second component (F) under driving of the first component (E), and the second damping structure (2) is driven by the connecting piece (3) to rotate about a second axis (Q2) relative to the second component (F). Both the first axis (Q1) and the second axis (Q2) extend in a second direction (Y), and the second direction (Y) is perpendicular to the first direction (X). The hinge mechanism (100) can provide a large damping force when a stand (81) of the electronic device (200) has a small width, thereby achieving a balance between stability of support by and a miniaturization design of the stand (81).

## Description

This application claims priority to Chinese Patent Application No. 202311191742.2, filed with the China National Intellectual Property Administration on September 14, 2023 and entitled "HINGE MECHANISM AND ELECTRONIC DEVICE", which is incorporated herein by reference in its entirety.

### TECHNICAL FIELD

This application relates to the field of hinge technologies, and in particular, to a hinge mechanism and an electronic device.

### BACKGROUND

Portable electronic devices such as foldable-screen mobile phones or tablet computers are large in size and inconvenient to hold for a long time, and therefore often need to be placed on a desktop for use. To stably support such an electronic product on the desktop, a stand is usually provided. Stands may be classified into two types: an externally disposed stand and a built-in stand. The externally disposed stand means to mount an external stand on the electronic device, and has a plurality of forms, for example, may be a metal stand, a plastic stand, or a foldable stand. Alternatively, a leather case of the electronic device is set to be of a foldable structure, to serve as a stand, and the like. A disadvantage of the externally disposed stand is that the stand is inconvenient to carry. The stand needs to be assembled with the electronic device during use, and needs to be disassembled after use, resulting in low convenience. If an externally disposed device such as the leather case is mounted on the electronic device for a long time, the electronic device is excessively heavy, resulting in poor user experience. To improve portability of the stand, make it more convenient for a user to use the stand, and improve user experience, some manufacturers directly dispose the stand on a housing of the electronic device when designing the electronic device, to form a built-in stand of the electronic device.

The built-in stand of the electronic device is usually connected to an electronic device body through a hinge mechanism, so that the stand is capable of rotating relative to the electronic device body, to switch between a stowed state and an open state. When the stand is in the stowed state, the stand is attached to the electronic device body, making it convenient to hold and carry the electronic device. When the stand is in the open state, the stand is opened at a specific angle relative to the electronic device body, to support the electronic device on the desktop. The hinge mechanism includes a damping structure, and the damping structure may generate a damping force, so that the stand can be suspended at a specific angle during rotation. Stability of supporting the electronic device on the desktop is directly determined based on the damping force of the damping structure. However, in an existing electronic device with a built-in stand, the damping force of the damping structure is related to a length of the damping structure. Usually, the damping structure needs to be set to be long to implement stable support. A width of the stand corresponds to the length of the damping structure. When the damping structure has a long length, the width of the stand is increased, resulting in an overall large size of the stand.

For example, some hinge mechanisms include a rotating shaft and a sleeve. The rotating shaft is sleeved in the sleeve, and the rotating shaft and the sleeve rotate relative to each other. One of the electronic device body and the stand is connected to the sleeve, and the other is connected to the rotating shaft. In this way, the stand is capable of rotating about an axis relative to the electronic device body, and an axis direction is the same as an axial direction of the rotating shaft. When the rotating shaft and the sleeve rotate relative to each other, a damping force is generated due to mutual friction. A larger contact area between the rotating shaft and the sleeve indicates a larger damping force. To obtain a sufficient damping force, lengths of the rotating shaft and the sleeve may be increased in the axis direction. The width of the stand (a size of the stand in the axis direction) is positively correlated with the lengths of the rotating shaft and the sleeve. When the lengths of the rotating shaft and the sleeve are increased, the width of the stand also needs to be increased. Alternatively, a plurality of pairs of rotating shafts and sleeves that fit with each other may be disposed in the axis direction, and each of the plurality of pairs of rotating shafts and sleeves provides a damping force. In this case, the stand needs to be connected to each pair of rotating shaft and sleeve. A larger quantity of rotating shafts and sleeves indicates a larger width of the stand. Therefore, in either case, the width of the stand is increased, resulting in a large size of the stand. Consequently, the stand occupies a large area on the housing of the electronic device. This causes problems such as a large appearance step difference of the electronic device and low structural strength of the housing, and is not conducive to a thin and lightweight design of the electronic device.

It may be learned that in the conventional technology, the hinge mechanism in the electronic device with a built-in stand cannot provide a large damping force when the stand has a small width, making it difficult to achieve a balance between stability of support by and a miniaturization design of the stand.

### SUMMARY

According to a hinge mechanism and an electronic device provided in embodiments of this application, a problem, in the conventional technology, that a hinge mechanism in an electronic device with a built-in stand cannot provide a large damping force when the stand has a small width, making it difficult to achieve a balance between stability of support by and a miniaturization design of the stand is resolved.

An embodiment of this application provides a hinge mechanism, configured to connect a first component and a second component. The first component is rotatably connected to the second component about a first axis. The hinge mechanism includes a first damping structure, a second damping structure, and a connecting piece. The first damping structure is mounted on the first component. The first damping structure and the second damping structure are spaced apart in a first direction and are connected through the connecting piece.

When the first damping structure rotates about the first axis relative to the second component under driving of the first component, the second damping structure is driven by the connecting piece to rotate about a second axis relative to the second component. Both the first axis and the second axis extend in a second direction, and the second direction is perpendicular to the first direction.

The hinge mechanism provided in this embodiment of this application may be used in an electronic device. The first component may be a stand, and the second component may be an electronic device body. The electronic device body and the stand may be rotatably connected through the hinge mechanism, and the stand is capable of rotating about the first axis relative to the electronic device body. Two damping structures are disposed in the hinge mechanism, and the two damping structures are linked through the connecting piece. When the stand and the electronic device body rotate relative to each other, both the two damping structures provide damping forces, and the damping forces of the damping structures are superimposed together to support the electronic device body. The first damping structure and the second damping structure are disposed in the first direction, the stand rotates about the first axis relative to the electronic device body, the first axis extends in the second direction, and the first direction and the second direction are perpendicular to each other. This may be understood as that an arrangement direction of the two damping structures is perpendicular to an axis direction in which the stand rotates.

In this structure, the stand is mounted only on the first damping structure, and a width of the stand (a size of the stand in the second direction) is related only to a size of the first damping structure in the second direction. However, a support force for supporting the electronic device body by the stand is obtained by superimposing damping forces of the first damping structure and the second damping structure. When the damping force of the first damping structure is insufficient, the second damping structure may compensate. Therefore, the size of the first damping structure can be reduced in the second direction, and the width of the stand can be correspondingly reduced. In addition, the second damping structure may be designed with a large size, to provide a sufficient damping force, so as to ensure stability when the stand supports the electronic device body.

It may be learned that the hinge mechanism provided in this embodiment of this application can provide a large damping force when the stand of the electronic device has a small width, thereby achieving a balance between stability of support by and a miniaturization design of the stand.

In some embodiments, the first damping structure includes a first rotating shaft and a first sleeve, and the first rotating shaft is sleeved in the first sleeve, and is capable of rotating about a third axis relative to the first sleeve. The second damping structure includes a second rotating shaft and a second sleeve, and the second rotating shaft is sleeved in the second sleeve, and is capable of rotating about a fourth axis relative to the second sleeve.

The first rotating shaft is mounted on the first component, and the first sleeve is mounted on the first component through the first rotating shaft. Both the first sleeve and the second sleeve are connected to the connecting piece and are fastened relative to the connecting piece, to connect the first damping structure and the second damping structure through the connecting piece.

Both the third axis and the fourth axis extend in the second direction, and all of the first axis, the second axis, the third axis, and the fourth axis are mutually spaced apart. A distance between the first axis and the second axis is equal to a distance between the third axis and the fourth axis, and a distance between the first axis and the third axis is equal to a distance between the second axis and the fourth axis.

According to the foregoing solution, on a plane perpendicular to the second direction, the first axis, the second axis, the third axis, and the fourth axis form a parallelogram structure, that is, the second component, the first damping structure, the second damping structure, and the connecting piece form a four-bar linkage structure.

In some embodiments, a first limiting portion is disposed in the first sleeve, a partial outer surface of the first rotating shaft in a circumferential direction of the first rotating shaft is set to a flat surface, the first limiting portion is of an elastic structure, and when the first rotating shaft rotates to a first position relative to the first sleeve, the first limiting portion and the first rotating shaft fit with each other through the flat surface. A second limiting portion is disposed in the second sleeve, a partial outer surface of the second rotating shaft in a circumferential direction of the second rotating shaft is set to a flat surface, the second limiting portion is of an elastic structure, and when the second rotating shaft rotates to a second position relative to the second sleeve, the second limiting portion and the second rotating shaft fit with each other through the flat surface.

According to the foregoing solution, a rotation angle of each rotating shaft may be limited through the limiting portion, so that the damping force of each damping structure varies with an angle at which the stand is opened, to provide a user with a changed hand feeling and remind the user of an optimal angle for using the stand.

In some embodiments, the connecting piece is set to a connecting rod, and two ends of the connecting rod respectively form the first sleeve and the second sleeve. That is, both the first sleeve and the second sleeve are integrally formed with the connecting piece. A structure is simple and easy to process.

In some embodiments, the hinge mechanism further includes:
a first fastener, where the first fastener is fastened to the first component, the first rotating shaft in the first damping structure is mounted on the first fastener, and the first damping structure is capable of being mounted on the first component through the first fastener; and
a second fastener, where the second fastener is fastened to the second component, the second rotating shaft in the second damping structure is mounted on the second fastener, and the second damping structure is capable of being mounted on the second component through the second fastener.

The first fastener is capable of rotating about the first axis relative to the second fastener, so that the first component is capable of rotating about the first axis relative to the second component.

According to the foregoing solution, the second fastener is fastened to the electronic device body, and the stand is fastened to the first fastener, and is rotatably connected to the second fastener through the first fastener, to be further rotatably connected to the electronic device body. When the user rotates the stand, the stand drives the first fastener to rotate relative to the second fastener. Because the second fastener is fastened relative to the electronic device body, the first fastener rotates relative to the electronic device body, and the stand rotates relative to the electronic device body.

In some embodiments, the first rotating shaft in the first damping structure is fastened to the first fastener. In this structure, the first rotating shaft and the first fastener do not rotate relative to each other, so that the damping force of the first damping structure can be better transferred to the stand.

In some embodiments, the first fastener is slidably connected to the second fastener, so that the first fastener is capable of rotating about the first axis relative to the second fastener, and the first damping structure is capable of rotating relative to the second fastener under driving of the first fastener. The second damping structure is slidably connected to the second fastener, so that the second damping structure is capable of rotating about the second axis relative to the second fastener.

In some embodiments, the second fastener includes a base body extending in the second direction and two extension arms respectively connected to two ends of the base body in the second direction. Each of the two extension arms extends in the first direction and protrudes from the base body toward a same side, so that mounting space is enclosed between the two extension arms and the base body. All of the first damping structure, the second damping structure, the connecting piece, and the first fastener are mounted in the mounting space. In the first direction, the second damping structure is located on a side that is of the first damping structure and that is close to the base body, and the first fastener is located on a side that is of the first damping structure and that is away from the base body.

The first fastener includes a base, a mounting portion, and two rotating arms. The base is fastened to the first component, the mounting portion is connected to the base, and protrudes from the base in the first direction toward a side on which the first damping structure is located, and the first rotating shaft in the first damping structure is mounted on the mounting portion.

The two rotating arms are respectively connected to two ends of the base in the second direction, the two rotating arms are in a one-to-one correspondence with the two extension arms of the second fastener, and each of the two rotating arms is slidably connected to a corresponding extension arm through a first sliding structure, so that the first fastener is capable of rotating about the first axis relative to the second fastener.

The first sliding structure includes an arc-shaped sliding groove and an arc-shaped slider that are slidably connected. One of the arc-shaped sliding groove and the arc-shaped slider in the first sliding structure is disposed on the rotating arm of the first fastener, and the other is disposed on the extension arm of the second fastener.

In some possible embodiments, the arc-shaped sliding groove in the first sliding structure is disposed on the rotating arm of the first fastener, and the arc-shaped slider is disposed on the extension arm of the second fastener.

In some embodiments, the mounting portion includes two bosses spaced apart in the second direction, the first damping structure is located between the two bosses, a through-hole is disposed on each of the two bosses, and two ends of the first rotating shaft in the first damping structure protrude from the first sleeve, and respectively penetrate through the through-holes on the two bosses. In this structure, the first fastener can drive the first rotating shaft to move, so that the first damping structure is capable of rotating relative to the second component.

In some possible embodiments, the two ends of the first rotating shaft are fastened to the two bosses, so that the first rotating shaft is fastened to the first fastener.

In some embodiments, the first fastener further includes a bump connected to the base, and the bump protrudes from the base in the first direction toward a side facing away from the first damping structure, and is built in the first component.

According to the foregoing solution, connection strength between a mounting member and the first fastener can be improved.

In some embodiments, the second damping structure further includes two shaft sleeves spaced apart in the second direction, and the two shaft sleeves are respectively sleeved at two ends of the second rotating shaft. The two shaft sleeves are in a one-to-one correspondence with the two extension arms of the second fastener, and each of the two shaft sleeves is slidably connected to a corresponding extension arm through a second sliding structure, so that the second damping structure is capable of rotating about the second axis relative to the second fastener.

The second sliding structure includes an arc-shaped slider and an arc-shaped sliding groove that are slidably connected to each other. One of the arc-shaped slider and the arc-shaped sliding groove in the second sliding structure is disposed on the shaft sleeve, and the other is disposed on the extension arm of the second fastener.

In some possible embodiments, the arc-shaped slider in the second sliding structure is disposed on the shaft sleeve, and the arc-shaped sliding groove is disposed on the extension arm of the second fastener.

In some embodiments, the second fastener has two fastening portions. Each of the two fastening portions includes a first part extending in the second direction and a second part extending in the first direction. The first part and the second part are connected. First parts of the two fastening portions are connected and fastened to form the base body of the second fastener. Second parts of the two fastening portions respectively form the two extension arms of the second fastener.

According to the foregoing solution, the second fastener is of a split structure, the second fastener is split into two fastening portions, and each fastening portion includes one extension arm and a part of the base body, to facilitate assembly of the hinge mechanism.

An embodiment of this application further provides an electronic device, including an electronic device body and a stand, and further including the hinge mechanism provided in any one of the foregoing embodiments. One of the electronic device body and the stand is configured as a first component, and the other is configured as a second component, to rotatably connect the electronic device body and the stand through the hinge mechanism. The electronic device uses the hinge mechanism provided in this application. The stand has a small width, the stand occupies a small area on a housing of the electronic device, an appearance step difference of the electronic device is small, and structural strength is high. This facilitates a thin and lightweight design of the electronic device.

In some embodiments, the stand is configured as the first component, and the electronic device body is configured as the second component. The electronic device body includes a display screen, a middle frame, and a rear cover. The middle frame includes a bottom plate and an outer frame. The display screen and the rear cover are respectively mounted at two ends of the outer frame in a third direction, and the bottom plate is located between the display screen and the rear cover. The third direction is perpendicular to a first direction and perpendicular to a second direction.

A hollowed-out portion is disposed on the rear cover of the electronic device body, the hinge mechanism and the stand are arranged on the bottom plate of the middle frame in the first direction, and in the third direction, the stand and the hinge mechanism are correspondingly disposed in the hollowed-out portion on the rear cover.

The stand includes a stand body and a mounting member. The stand body is set to be of a plate-like structure. The mounting member is connected to the stand body, and is located, in the third direction, on a side that is of the stand body and that faces the display screen. The hinge mechanism is mounted on the mounting member of the stand, so that the stand is capable of rotating about a first axis relative to the electronic device body, to switch between a stowed state and an open state. When the stand is in the stowed state, the stand body is integrally built in the hollowed-out portion on the rear cover. When the stand is in the open state, at least a partial structure of the stand body is separated from the hollowed-out portion and protrudes from an outer surface of the electronic device body.

According to the foregoing solution, when the stand is in the stowed state, the stand body may be built in the electronic device body, and does not protrude from the electronic device body. Therefore, the stand does not cause an increase in a local thickness of the electronic device, making the electronic device thinner and more lightweight.

In some embodiments, the electronic device body further includes a cover plate. The cover plate is disposed in the hollowed-out portion on the rear cover, and the cover plate is disposed, in the first direction, on a side that is of the stand and that faces the hinge mechanism, and is connected to the stand body, so that the cover plate and the stand form a stand structure. When the stand is in the stowed state, a projection of the stand structure on the display screen in the third direction coincides with a projection of the hollowed-out portion on the display screen in the third direction.

A stepped structure is disposed on the bottom plate of the middle frame. The stepped structure is connected to the bottom plate, and is located, in the third direction, on a side that is of the bottom plate and that faces away from the display screen. The stepped structure includes a top surface and a side surface that are perpendicular to each other. The side surface extends in the third direction, and the top surface is connected to an end that is of the side surface and that is away from the display screen in the third direction. When the stand is in the stowed state, the top surface is opposite to the stand body of the stand. When the stand is in the open state, an opening is formed between the stand body and the top surface of the stepped structure.

According to the foregoing solution, the stepped structure has a specific thickness. When the stand body rotates and is opened, the top surface of the stepped structure may shield an opening between the stand body and the electronic device body, so that a user sees the top surface of the stepped structure instead of another electronic component in the electronic device. This improves electronic aesthetics and can protect the electronic component in the electronic device.

In some embodiments, the first axis is located on a surface that is of the stand structure and that is away from the display screen in the third direction, and is located at a joint between the cover plate and the stand body.

According to the foregoing solution, in a process in which the stand rotates relative to the electronic device body, an upper surface of the stand body and an upper surface of the cover plate always fit with each other through a gap, so that the electronic device has a simple and aesthetically pleasing appearance and a smooth plane transition.

In some embodiments, the mounting member of the stand is set to be of an arc-shaped structure, an accommodation groove is disposed in the mounting member, and a partial structure of the hinge mechanism is located in the accommodation groove. When the stand is in the stowed state, the mounting member is integrally located, in the first direction, on a side that is of the side surface of the stepped structure and that faces the cover plate. When the stand is in the open state, at least a partial structure of the mounting member is located, in the first direction, on a side that is of the side surface of the stepped structure and that faces away from the cover plate.

According to the foregoing solution, the arc-shaped mounting member is located in a gap between the stepped structure and the hinge mechanism. When the stand rotates, the arc-shaped structure rotates in the gap. When the stand body is opened at a specific angle relative to the electronic device body, the arc-shaped structure is exposed with the stand body, shielding the gap between the stepped structure and the hinge mechanism, and shielding a gap between the stand body and the hinge mechanism, thereby implementing comprehensive shielding for the hinge mechanism.

In some possible embodiments, the accommodation groove in the mounting member includes a first accommodation groove and two second accommodation grooves. All of the first accommodation groove and the two second accommodation grooves are spaced apart in the second direction, and the first accommodation groove is located between the two second accommodation grooves.

When the hinge mechanism includes a first fastener, and the first fastener includes two rotating arms and a bump, at least a partial structure of the bump is located in the first accommodation groove, the two rotating arms are in a one-to-one correspondence with the two second accommodation grooves, and at least a partial structure of each rotating arm is located in a corresponding second accommodation groove.

According to the foregoing solution, a connection area between the stand and the hinge mechanism is increased to improve connection reliability between the stand and the hinge mechanism.

### BRIEF DESCRIPTION OF DRAWINGS

FIG. 1 is a diagram of a structure of an electronic device;
FIG. 2 is a diagram of a structure of another electronic device;
FIG. 3a and FIG. 3b are diagrams of three-dimensional structures of an electronic device from different perspectives according to an embodiment of this application, where an electronic device body is in an unfolded state;
FIG. 4 is a diagram of a three-dimensional structure of an electronic device according to an embodiment of this application, where an electronic device body is in a folded state;
FIG. 5 is a rear view of an electronic device according to an embodiment of this application, where an electronic device body is in an unfolded state;
FIG. 6 is a rear view of an electronic device with a cover plate removed according to an embodiment of this application;
FIG. 7 is a partial enlarged view of a part D in FIG. 3b;
FIG. 8 is a diagram of a fitting relationship between a stand and a housing in an electronic device according to an embodiment of this application, where the stand is in an open state;
FIG. 9a is a diagram of a cross-section structure of an electronic device according to an embodiment of this application, where a stand is in a stowed state;
FIG. 9b is a diagram of a cross-section structure of an electronic device according to an embodiment of this application, where a stand is in an open state;
FIG. 10a is a diagram of a fitting relationship between a stand, a hinge mechanism, and a stepped structure in an electronic device according to an embodiment of this application, where the stand is in a stowed state;
FIG. 10b and FIG. 10c are diagrams of a fitting relationship between a stand, a hinge mechanism, and a stepped structure in an electronic device according to an embodiment of this application, where the stand is in an open state, and the stand is opened at different angles in FIG. 10b and FIG. 10c;
FIG. 11 and FIG. 12 are diagrams of a principle structure of a hinge mechanism according to an embodiment of this application;
FIG. 13 is a diagram of a three-dimensional structure of a hinge mechanism according to an embodiment of this application;
FIG. 14 is a diagram of a top-view structure of a hinge mechanism according to an embodiment of this application;
FIG. 15 is a diagram of a cross-section structure in a direction A-A in FIG. 14;
FIG. 16 is a diagram of a cross-section structure of a hinge mechanism in another state in a direction A-A in FIG. 14 according to an embodiment of this application;
FIG. 17 is a diagram of an exploded structure of a hinge mechanism according to an embodiment of this application;
FIG. 18a is a diagram of a connection structure between a first damping structure, a second damping structure, and a connecting piece in a hinge mechanism according to an embodiment of this application;
FIG. 18b is a diagram of a connection structure between a first damping structure, a second damping structure, and a connecting piece in a hinge mechanism at another angle according to an embodiment of this application;
FIG. 19 is a diagram of a structure of a first fastener in a hinge mechanism according to an embodiment of this application;
FIG. 20 is a diagram of a connection structure between a first fastener and a first damping structure in a hinge mechanism according to an embodiment of this application;
FIG. 21 is a diagram of a structure of a second fastener in a hinge mechanism according to an embodiment of this application;
FIG. 22 is a diagram of a fitting relationship between a first fastener and a second fastener in a hinge mechanism according to an embodiment of this application;
FIG. 23 is a diagram of a fitting relationship between a second fastener and a second damping structure in a hinge mechanism according to an embodiment of this application;
FIG. 24 is a diagram of exploded structures of a hinge mechanism and a stand according to an embodiment of this application;
FIG. 25 is a diagram of a connection structure between a hinge mechanism and a stand according to an embodiment of this application;
FIG. 26a is a sectional view in a direction B-B in FIG. 25; and
FIG. 26b is a sectional view in a direction C-C in FIG. 25.

### Description of reference numerals:

A solution:
   100': electronic device;
   1': electronic device body; 2': stand;
   3': hinge mechanism; 31': damping structure; 311': rotating shaft; 312': sleeve;
   4': connecting piece;
   Q': first axis; Y': axis direction
Another solution:
   100": electronic device;
   1": electronic device body; 2": stand;
   3": hinge mechanism; 31": damping structure; 311": rotating shaft; 312": sleeve;
   4": connecting piece;
   Q": first axis; Y": axis direction
This application:
   100: hinge mechanism;
   1: first damping structure; 11: first rotating shaft; 110: flat surface;
   12: first sleeve; 13: first limiting portion;
   2: second damping structure; 21: second rotating shaft; 210: flat surface;
   22: second sleeve; 23: second limiting portion; 24: shaft sleeve;
   3: connecting piece;
   4: first fastener; 41: base; 410: through-hole;
   42: mounting portion; 421: boss; 4210: through-hole;
   43: rotating arm; 44: bump;
   5: second fastener; 50: mounting space; 51: base body; 510: fastening hole;
   52: extension arm; 521: extension platform; 5210: fastening hole;
   53: fastening portion; 531: first part; 532: second part;
   61: first sliding structure; 611: arc-shaped sliding groove; 612: arc-shaped slider;
   62: second sliding structure; 621: arc-shaped sliding groove; 622: arc-shaped slider;
   200: electronic device;
   7: electronic device body;
   71: display screen; 711: first part; 712: second part; 713: foldable part;
   72: housing assembly; 721: first housing; 722: second housing; 723: hinge apparatus;
   724: middle frame; 7241: outer frame; 7242: bottom plate;
   725: rear cover; 7250: hollowed-out portion; 726: beam;
   8: stand structure; 81: stand; 811: stand body;
   812: mounting member; 8120: fastening hole;
   8121: first accommodation groove; 8122: second accommodation groove; 8123: connecting wall;
   82: cover plate;
   9: stepped structure; 91: top surface; 92: side surface;
   E: first component; F: second component;
   Q1: first axis; Q2: second axis; Q3: third axis; Q4: fourth axis;
   X: first direction; Y: second direction; Z: third direction

### DESCRIPTION OF EMBODIMENTS

The following describes implementations of this application by using specific embodiments. A person skilled in the art may easily learn of other advantages and effects of this application based on content disclosed in this specification. Although this application is described with reference to some embodiments, it does not mean that features of this application are limited only to this implementation. On the contrary, an objective of describing this application with reference to an implementation is to cover another option or modification that may be derived based on the claims of this application. To provide an in-depth understanding of this application, the following descriptions include many specific details. This application may alternatively be implemented without using these details. In addition, to avoid confusion or blurring a focus of this application, some specific details are omitted from the descriptions. It should be noted that when there is no conflict, embodiments of this application and the features in embodiments may be mutually combined.

It should be noted that in this specification, similar reference numerals and letters in the following accompanying drawings indicate similar items. Therefore, once an item is defined in an accompanying drawing, the item does not need to be further defined or interpreted in following accompanying drawings.

In the descriptions of this application, it should be noted that orientations or position relationships indicated by terms "center", "upper", "lower", "left", "right", "vertical", "horizontal", "inner", "outer", "top", "bottom" and the like are orientations or position relationships shown based on the accompanying drawings, and are merely used for ease of describing this application and simplifying the descriptions, rather than indicating or implying that a described apparatus or element needs to have a specific orientation or needs to be constructed and operated in a specific orientation, and therefore cannot be understood as a limitation on this application. In addition, terms "first" and "second" are merely used for description, and cannot be understood as an indication or implication of relative importance.

In the descriptions of this application, it should be noted that unless otherwise explicitly specified and limited, the terms "mounting", "connect", and "connection" should be understood in a broad sense. For example, there may be fastening, a detachable connection, an integrated connection, a mechanical connection, an electrical connection, a direct connection, an indirect connection implemented through an intermediate medium, or internal communication between two elements. A person of ordinary skill in the art may understand specific meanings of the foregoing terms in this application based on specific situations.

In the descriptions of this application, it should be understood that in this application, an "electrical connection" may be understood as physical contact and electrical conduction between components, or may be understood as a form in which different components in a line structure are connected through a physical line that can transmit an electrical signal, for example, a printed circuit board (printed circuit board, PCB) copper foil or a conducting wire.

In the descriptions of this application, it should be noted that mutual perpendicularity in this application is not absolute perpendicularity, and approximate perpendicularity (for example, an included angle between two structural features is 89.9°) caused by a processing error and an assembly error is also in a range of mutual perpendicularity in this application. Mutual parallelism in this application is not absolute parallelism, and approximate parallelism (for example, an included angle between two structural features is 0.1°) caused by a processing error and an assembly error is also in a range of mutual parallelism in this application. Axial symmetry in this application is not absolute axial symmetry, and approximate axial symmetry (for example, a partial structure is offset by a specific distance or angle relative to a symmetry axis) caused by a processing error and an assembly error is also in a range of axial symmetry in this application. Central symmetry in this application is not absolute central symmetry, and approximate central symmetry (for example, a partial structure is offset by a specific distance or angle relative to a symmetry axis) caused by a processing error and an assembly error is also in a range of central symmetry in this application. This is not specifically limited in this application.

To make the objectives, technical solutions, and advantages of this application clearer, the following further describes the implementations of this application in detail with reference to the accompanying drawings.

A portable electronic device such as a foldable-screen mobile phone or a tablet computer is large in size and inconvenient to hold for a long time, and therefore often needs to be placed on a desktop for use. To stably support such an electronic product on the desktop, a stand is usually provided. Stands may be classified into two types: an externally disposed stand and a built-in stand. The externally disposed stand means to mount an external stand on the electronic device, and has a plurality of forms, for example, may be a metal stand, a plastic stand, or a foldable stand. Alternatively, a leather case of the electronic device is set to be of a foldable structure, to serve as a stand, and the like. A disadvantage of the externally disposed stand is that the stand is inconvenient to carry. The stand needs to be assembled with the electronic device during use, and needs to be disassembled after use, resulting in low convenience. If an externally disposed device such as the leather case is mounted on the electronic device for a long time, the electronic device is excessively heavy, resulting in poor user experience. To improve portability of the stand, make it more convenient for a user to use the stand, and improve user experience, some manufacturers directly dispose the stand on a housing of the electronic device when designing the electronic device, to form a built-in stand of the electronic device.

The built-in stand of the electronic device is usually connected to an electronic device body through a hinge mechanism, so that the stand is capable of rotating relative to the electronic device body, to switch between a stowed state and an open state. When the stand is in the stowed state, the stand is attached to the electronic device body, making it convenient to hold and carry the electronic device. When the stand is in the open state, the stand is opened at a specific angle relative to the electronic device body, to support the electronic device body on the desktop. The hinge mechanism includes a damping structure, and the damping structure may generate a damping force, so that the stand can be suspended at a specific angle during rotation. Stability of supporting the electronic device on the desktop is directly determined based on the damping force of the damping structure. However, in an existing electronic device with a built-in stand, the damping force of the damping structure is related to a length of the damping structure. Usually, the damping structure needs to be set to be long to implement stable support. A width of the stand corresponds to the length of the damping structure. When the damping structure has a long length, the width of the stand is increased, resulting in an overall large size of the stand. The following describes this problem with reference to several electronic devices with built-in stands and structures of hinge mechanisms thereof.

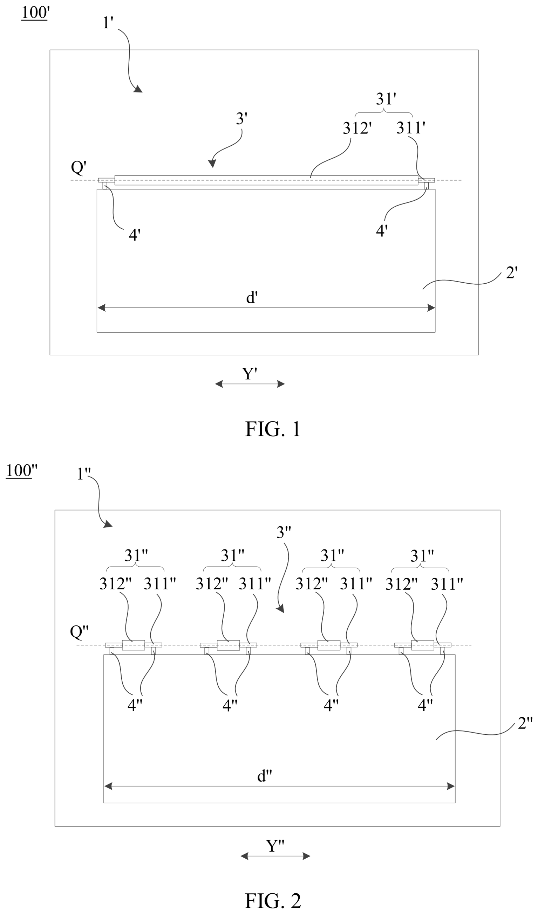

Refer to FIG. 1. FIG. 1 is a diagram of a structure of an electronic device.

As shown in FIG. 1, the electronic device 100' includes an electronic device body 1' and a stand 2'. The stand 2' is rotatably connected to the electronic device body 1' through a hinge mechanism 3', and is capable of rotating relative to the electronic device 100'. Specifically, the hinge mechanism 3' includes a damping structure 31'. The damping structure 31' may include a rotating shaft 311' and a sleeve 312'. The rotating shaft 311' is sleeved in the sleeve 312', and the rotating shaft 311' and the sleeve 312' can rotate relative to each other. One of the electronic device body 1' and the stand 2' is connected to the sleeve 312', and the other is connected to the rotating shaft 311'. In this way, the stand 2' is capable of rotating about a first axis Q' relative to the electronic device body 1'. In the scenario shown in FIG. 1, the stand 2' is connected and fastened to the rotating shaft 311' through a connecting piece 4', and the sleeve 312' is fastened to the electronic device body 1'. An axis direction Y' (a direction in which the first axis Q' is located) is the same as an axial direction of the rotating shaft 311'. Alternatively, it may be understood that an axis center of the rotating shaft 311' is the first axis Q'.

When the rotating shaft 311' and the sleeve 312' rotate relative to each other, a damping force is generated due to mutual friction. The damping force may be used as a force for supporting the electronic device body 1' by the stand 2'. A larger contact area between the rotating shaft 311' and the sleeve 312' indicates a larger damping force and higher stability of supporting the electronic device 100' by the stand 2'. However, the rotating shaft 311' rotates relative to the sleeve 312' under driving of the stand 2'. To improve rotational stability of the rotating shaft 311' and prevent the rotating shaft 311' from being stuck, it needs to be ensured that the rotating shaft 311' is evenly subject to a force. In this case, each of two ends of the rotating shaft 311' usually needs to be connected to the stand. For example, in FIG. 1, each of the two ends of the rotating shaft 311' is fastened to each of two ends of the stand 2' through one connecting piece 4'. In this case, a width d' of the stand 2' (a size of the stand 2' in the axis direction Y') is positively correlated with lengths of the rotating shaft 311' and the sleeve 312'. When the lengths of the rotating shaft 311' and the sleeve 312' are increased, the width d' of the stand 2' also needs to be increased. To stably support the electronic device body 1' and obtain a sufficient damping force, the lengths of the rotating shaft 311' and the sleeve 312' may be increased in the axis direction Y', to increase the contact area between the rotating shaft 311' and the sleeve 312'. In this case, the width d' of the stand 2' is large.

Refer to FIG. 2. FIG. 2 is a diagram of a structure of another electronic device.

As shown in FIG. 2, the electronic device 100" includes an electronic device body 1" and a stand 2". The stand 2" is rotatably connected to the electronic device body 1" through a hinge mechanism 3", and is capable of rotating relative to the electronic device 100". Different from the electronic device 100' shown in FIG. 1, the hinge mechanism 3" in the electronic device 100" includes a plurality of damping structures 31" (four damping structures are shown in the figure) disposed in an axis direction Y". Each damping structure 31" includes one pair of rotating shaft 311" and sleeve 312" that fit with each other. The stand 2" may be connected to the rotating shaft 311" in each damping structure 31" through a connecting piece 4". During rotation, the stand 2" drives each rotating shaft 311" to rotate relative to a corresponding sleeve 312". Friction forces generated due to mutual friction between rotating shafts 311" and sleeves 312" in all the damping structures 31" are superimposed to form a damping force of the hinge mechanism 3" to support the electronic device body 1". In this structure, the plurality of damping structures 31" are arranged in the axis direction Y" (a direction in which a first axis Q" is located), and the stand 2" needs to be connected to the rotating shaft 311" in each damping structure 31". A larger quantity of damping structures 31" indicates a larger width d" of the stand 2". If it needs to be ensured that the electronic device body 1" is stably supported and there is a sufficient damping force, the quantity of damping structures 31" needs to be inevitably increased. In this case, the width d" of the stand 2" is large.

It may be learned from the foregoing two structures that the hinge mechanism in the electronic device with a built-in stand cannot provide a large damping force when the stand has a small width, making it difficult to achieve a balance between stability of support by and a miniaturization design of the stand.

A person skilled in the art may understand that the stand is usually mounted on a housing of the electronic device. If the width of the stand is large, an overall size of the stand is large, and a large area is occupied on the housing of the electronic device, resulting in a large appearance step difference of the electronic device. Because the stand and the housing of the electronic device are in a structure that can be separated, a groove usually needs to be dug at a position for accommodating the stand on the housing. This results in a reduced thickness of the housing at the position and reduced structural strength of the housing. In addition, to ensure flatness of an appearance of the electronic device, the stand is usually designed in a built-in manner, and is integrally built in the electronic device body when in a stowed state. When a thickness of the electronic device is fixed, an electronic component corresponding to a position of the stand inside the electronic device body needs to perform avoidance. A large size of the stand is not conducive to a spatial layout of the electronic component, causing a problem such as inability to mount some electronic components. To avoid such a problem, only the thickness of the electronic device can be increased to increase accommodation space for the electronic component. Therefore, a large size of the stand is not conducive to a thin and lightweight design of the electronic device.

To resolve the foregoing problem, this application provides a hinge mechanism. A damping structure is arranged perpendicular to an axis direction, so that a large damping force can be provided when a stand of an electronic device has a small width, thereby achieving a balance between stability of support by and a miniaturization design of the stand.

An embodiment of this application further provides an electronic device. The electronic device uses the hinge mechanism provided in this application. A stand has a small width, the stand occupies a small area on a housing of the electronic device, an appearance step difference of the electronic device is small, and structural strength is high. This facilitates a thin and lightweight design of the electronic device.

The electronic device provided in this application may be but is not limited to a mobile phone, a tablet computer, a display, a personal digital device, a smart wearable device, or the like. The mobile phone may be an integrated mobile phone, or may be a foldable-screen mobile phone. The following describes a structure of the electronic device by using the foldable-screen mobile phone as an example. It should be noted that the following descriptions of the structure of the electronic device are merely an example, and do not constitute a limitation on the electronic device provided in this application. Actually, the electronic device may include more or fewer components in the following examples and the accompanying drawings.

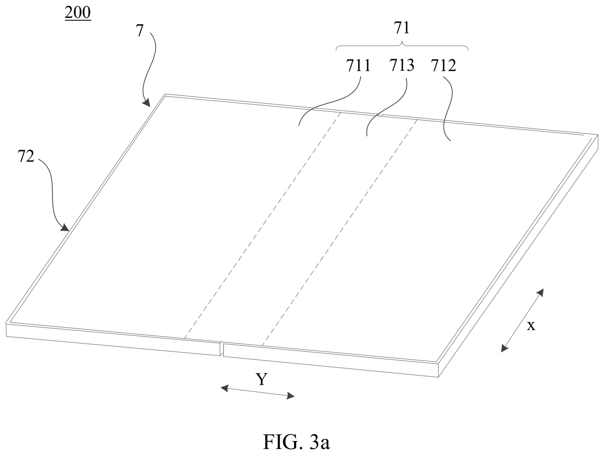

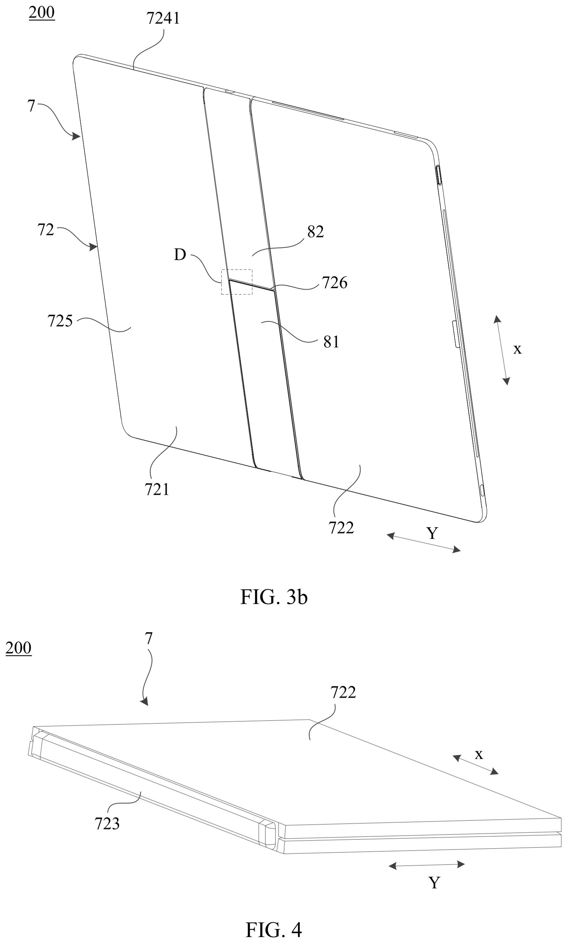

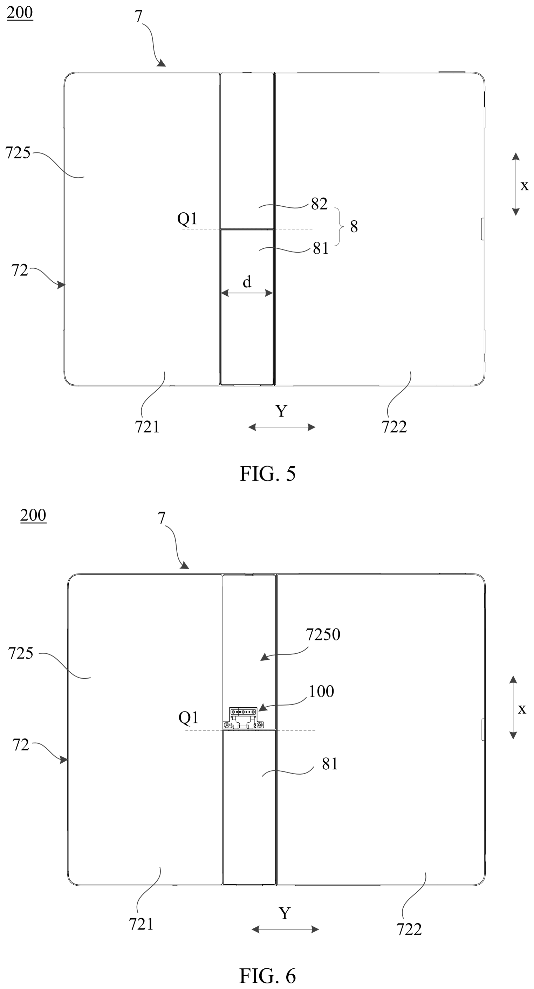

Refer to FIG. 3a to FIG. 6. FIG. 3a and FIG. 3b are diagrams of three-dimensional structures of an electronic device from different perspectives according to an embodiment of this application, where an electronic device body is in an unfolded state; FIG. 4 is a diagram of a three-dimensional structure of an electronic device according to an embodiment of this application, where an electronic device body is in a folded state; FIG. 5 is a rear view of an electronic device according to an embodiment of this application, where an electronic device body is in an unfolded state; and FIG. 6 is a rear view of an electronic device with a cover plate removed according to an embodiment of this application.

As shown in FIG. 3a to FIG. 6, the electronic device 200 includes an electronic device body 7 and a stand 81. The stand 81 is configured to support the electronic device body 7. A person skilled in the art may understand that a structure of the electronic device body 7 is not limited. In an implementation, the electronic device body 7 includes a display screen 71 and a housing assembly 72. The display screen 71 is mounted on the housing assembly 72, and the display screen 71 is configured to display an image and perform human-computer interaction. The housing assembly 72 is configured to support the display screen 71, and has internal accommodation space to accommodate and mount another electronic component. The electronic component includes but is not limited to a circuit board, a battery, a camera module, a microphone, a speaker, or the like. This is not limited in this application.

In an implementation, the housing assembly 72 includes a first housing 721, a second housing 722, and a hinge apparatus 723. Each of the first housing 721 and the second housing 722 has internal accommodation space to accommodate some electronic components. The first housing 721 and the second housing 722 are rotatably connected through the hinge apparatus 723, and can rotate relative to each other, so that the electronic device body 7 presents different use states in different use scenarios, including an unfolded state shown in FIG. 3a, FIG. 3b, FIG. 5, and FIG. 6, and a folded state shown in FIG. 4.

In an implementation, when the electronic device body 7 is in the unfolded state, an angle at which the electronic device body 7 is opened is 180°, that is, an included angle between the first housing 721 and the second housing 722 is 180°. A person skilled in the art may understand that the angle at which the electronic device body 7 is opened may alternatively be 90°, 120°, 210°, or the like. This is not limited in this application. In addition, slight deviations are allowed for angles described as examples in this application. For example, when the electronic device body 7 is in the unfolded state, an angle at which the first housing 721 and the second housing 722 are opened may be 180°, or may be approximately 180°, for example, 170°, 175°, 185°, or 190°. Other angles may be understood in a same manner below.

Further, both the first housing 721 and the second housing 722 can rotate about the hinge apparatus 723, so that the first housing 721 and the second housing 722 rotate relative to each other. When the first housing 721 and the second housing 722 rotate relative to each other to be coplanar, the electronic device body 7 is in the unfolded state. In this case, the included angle between the first housing 721 and the second housing 722 is 180°. When the first housing 721 and the second housing 722 rotate relative to each other to be stacked, the electronic device body 7 is in the folded state. In this case, it may be approximately considered that the included angle between the first housing 721 and the second housing 722 is 0°.

It should be noted that a structure of the display screen 71 and a manner of connecting the display screen 71 to the housing assembly 72 are not limited in this application.

As shown in FIG. 3a to FIG. 4, in an implementation, the display screen 71 is laid on one side of the housing assembly 72. The display screen 71 may be but is not limited to an organic light-emitting diode (organic light-emitting diode, OLED) display screen, an active-matrix organic light-emitting diode (active-matrix organic light-emitting diode, AMOLED) display screen, a quantum dot light-emitting diode (quantum dot light-emitting diode, QLED) display screen, or the like. The display screen 71 is connected to a side surface of the housing assembly 72, a side surface that is of the display screen 71 and that faces away from the housing assembly 72 is a display surface of the display screen 71, and the display surface is configured to display information and provide an interaction interface to a user.

In an implementation, the display screen 71 includes a first part 711, a second part 712, and a foldable part 713. The first part 711 is connected to the first housing 721, the second part 712 is connected to the second housing 722, and the foldable part 713 is located between the first part 711 and the second part 712. In a process of using the foldable electronic device body 7, the first part 711 and the second part 712 always remain in a planar state, and the foldable part 713 is bendable, to change an included angle between the first part 711 and the second part 712, so that the display screen 71 is folded or unfolded with movement of the housing assembly 72, to enable the foldable electronic device body 7 to switch between the folded state and the unfolded state. For example, in the display screen 71, at least a part of the foldable part 713 is made of a flexible material, so that the foldable part 713 is bendable.

Driven by the hinge apparatus 723, the display screen 71 is opened or closed together with the first housing 721 and the second housing 722. The foldable part 713 of the display screen 71 is flattened or bent, so that the first part 711 and the second part 712 rotate relative to each other. When the foldable electronic device body 7 is in an open state, the first part 711 and the second part 712 are in an unfolded state of being away from each other, the foldable part 713 is flattened, and display surfaces of the first part 711 and the second part 712 face a same direction. When the foldable electronic device body 7 is in a closed state, the first part 711 and the second part 712 are stacked relative to each other, the foldable part 713 is in a bent state, and display surfaces of the first part 711 and the second part 712 are opposite to each other or back-to-back.

It should be noted that the electronic device 200 provided in this application may be an outward foldable electronic device or an inward foldable electronic device. When the electronic device body 7 of the outward foldable electronic device is in the folded state, the display screen 71 surrounds an outer side of the housing assembly 72. Alternatively, it may be understood that the first part 711 and the second part 712 of the display screen 71 are disposed back-to-back, the housing assembly 72 is located between the first part 711 and the second part 712, and display surfaces of the first part 711 and the second part 712 are exposed to the user. When the electronic device body 7 of the inward foldable electronic device is in the folded state, the first part 711 and the second part 712 of the display screen 71 are opposite to each other, the display screen 71 is integrally accommodated inside the housing assembly 72, and the housing assembly 72 provides external protection to the display screen 71.

Further, the stand 81 is mounted on the housing assembly 72, and is located on a back surface of the housing assembly 72 (a surface that is of the housing assembly 72 and that faces away from the display screen 71 in a thickness direction of the electronic device 200). When the electronic device body 7 is in the unfolded state, the electronic device body 7 is large in size and inconvenient to hold for a long time, and may be supported by the stand 81 for use on a desktop. It should be noted that a specific position of the stand 81 on the housing assembly 72 is not limited. The stand 81 may be mounted on the first housing 721, may be mounted on the second housing 722, or may be mounted on both the first housing 721 and the second housing 722. As shown in FIG. 3b, FIG. 5, and FIG. 6, in an implementation, the stand 81 is mounted on the first housing 721.

A person skilled in the art may understand that a mounting position of the stand 81 on the first housing 721 and a fitting relationship between the stand 81 and the first housing 721 are not limited. With reference to the accompanying drawings, the following describes, by using an example, a structure that may be used.

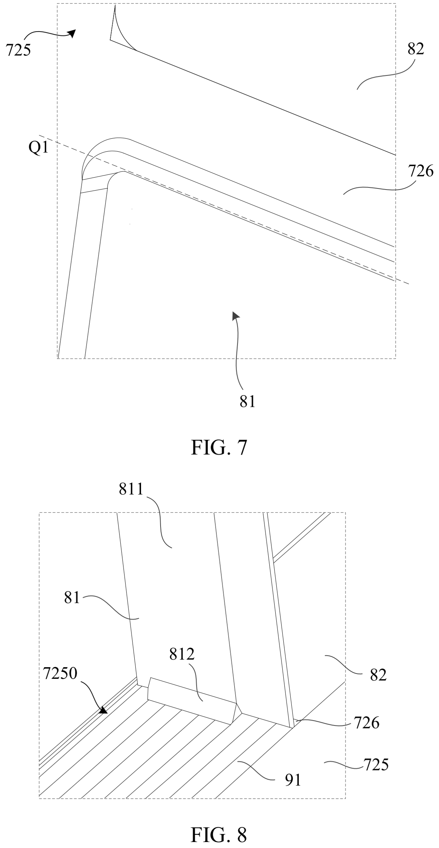

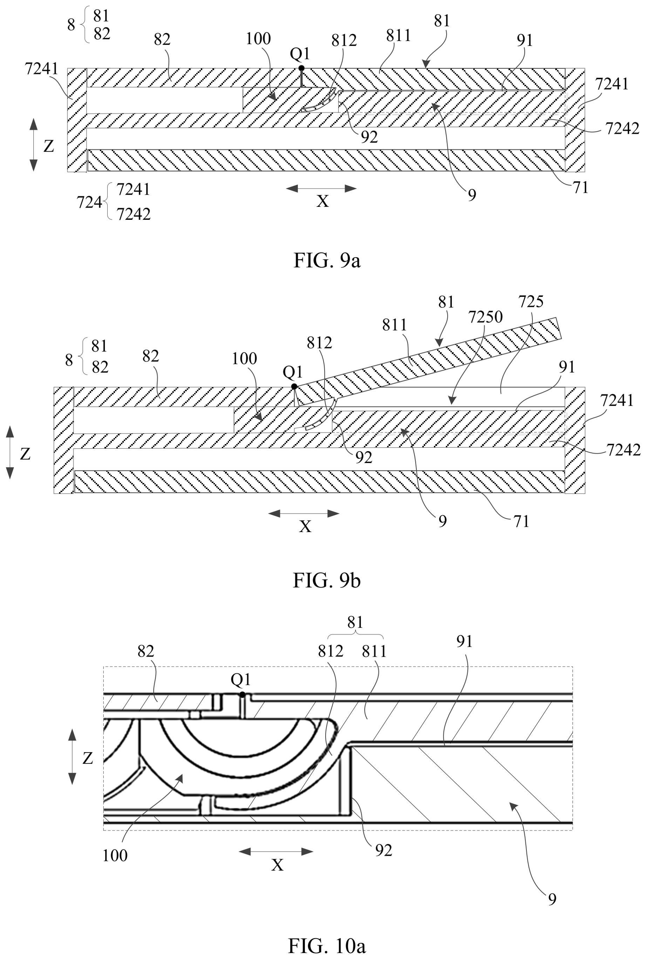

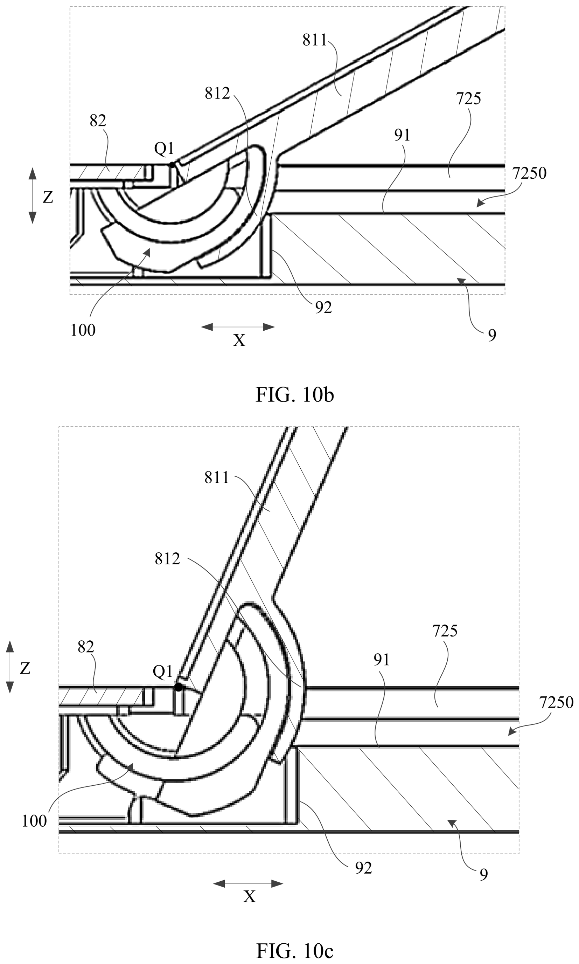

Refer to FIG. 7 to FIG. 10c. FIG. 7 is a partial enlarged view of a part D in FIG. 3b; FIG. 8 is a diagram of a fitting relationship between a stand and a housing in an electronic device according to an embodiment of this application, where the stand is in an open state; FIG. 9a is a diagram of a cross-section structure of an electronic device according to an embodiment of this application, where a stand is in a stowed state; FIG. 9b is a diagram of a cross-section structure of an electronic device according to an embodiment of this application, where a stand is in an open state; FIG. 10a is a diagram of a fitting relationship between a stand, a hinge mechanism, and a stepped structure in an electronic device according to an embodiment of this application, where the stand is in a stowed state; and FIG. 10b and FIG. 10c are diagrams of a fitting relationship between a stand, a hinge mechanism, and a stepped structure in an electronic device according to an embodiment of this application, where the stand is in an open state, and the stand is opened at different angles in FIG. 10b and FIG. 10c.

It should be noted that FIG. 9a and FIG. 9b are principle diagrams, are merely intended to indicate a fitting relationship between the hinge mechanism 100, the stand 81, and another component in the electronic device 200, and cannot constitute a limitation on a specific structure of the electronic device 200.

As shown in FIG. 3a to FIG. 10c, the electronic device 200 further includes the hinge mechanism 100. The electronic device body 7 and the stand 81 are rotatably connected through the hinge mechanism 100, and the stand 81 is capable of rotating about a first axis Q1 relative to the electronic device body 7, to switch between a stowed state and an open state. A direction in which the first axis Q1 is located is an axis direction in which the stand 81 rotates relative to the electronic device body 7. The first axis Q1 extends in a second direction Y, and the second direction Y is an axis direction and a width direction of the stand 81.

In an implementation, the hinge mechanism 100 and the stand 81 are arranged in a first direction X, and the first direction X is perpendicular to the second direction Y. Alternatively, it may be understood that the hinge mechanism 100 and the stand 81 are arranged in a direction perpendicular to an axis direction in which the electronic device rotates. A person skilled in the art may understand that a direction in which the stand 81 is disposed on the electronic device body 7 is not limited. For example, one of the first direction X and the second direction Y may be a length direction of the electronic device 200, and the other may be a width direction of the electronic device 200. Alternatively, both the first direction X and the second direction Y may be inclined toward a length direction of the electronic device 200, that is, the stand 81 is obliquely disposed on the electronic device body 7. In an implementation, the first direction X is the width direction of the electronic device 200, and the second direction Y is the length direction of the electronic device 200. For ease of description, the thickness direction of the electronic device 200 is defined as a third direction Z, and every two of the first direction X, the second direction Y, and the third direction Z are perpendicular to each other.

For example, when the stand 81 is in the stowed state, the stand 81 is integrally attached to the electronic device body 7. Alternatively, it may be understood that a thickness direction of the stand 81 is consistent with the thickness direction (the third direction Z) of the electronic device 200. When the stand 81 is in the open state, the stand 81 is opened at a specific angle relative to the electronic device body 7, and a thickness direction of the stand 81 is inconsistent with a thickness direction of the electronic device body 7. An angle at which the stand 81 and the electronic device body 7 are opened relative to each other is not limited, and may be a specific angle or any angle. For example, a damping structure in the hinge mechanism 100 may be designed, so that the stand 81 can be suspended at any angle within an allowed range of a stroke of the stand 81, and may support the electronic device body 7 at the any angle. Alternatively, some limiting structures may be disposed to limit a rotation stroke of the stand 81. When a combination with a design of a damping structure is made, the stand 81 can be suspended only at one or more specified angles to support the electronic device body 7.

In an implementation, a limiting structure may be disposed between the stand 81 and the electronic device body 7 (for example, on the hinge mechanism 100). When the stand 81 rotates relative to the electronic device body 7 to a specific angle (which may be designed based on a size of an actual product, for example, may be 60°, 75°, or 80°, and is not specifically limited), an angle at which the stand 81 and the electronic device 200 are opened reaches a maximum. In this case, an optimal use effect of placing the electronic device 200 on the desktop is achieved. In an implementation, a plurality of limiting structures may be disposed between the stand 81 and the electronic device body 7, and each limiting structure corresponds to a specific angle. When the stand 81 rotates to several specific angles, a damping force of the hinge mechanism 100 is large, and the electronic device 200 may be placed on the desktop at the several specific angles, to meet different use requirements. In an implementation, a limiting structure is disposed between the stand 81 and the electronic device body 7, and the limiting structure corresponds to a specific angle. The stand 81 may be suspended at any angle within an allowed range of a stroke of the stand 81, and may support the electronic device body 7. When the stand 81 is suspended at the specific angle, a use effect of supporting the electronic device body 7 by the stand 81 is best.

A person skilled in the art may understand that a structure of the first housing 721 is not limited. With reference to the accompanying drawings, the following describes, by using an example, a structure that may be used by the first housing 721 and a fitting relationship between the stand 81, the hinge mechanism 100, and the first housing 721. It should be noted that because the stand 81 is mounted on the first housing 721 in the foregoing embodiment, only the structure of the first housing 721 is described below, and a structure of the second housing 722 is not described. The second housing 722 may use a structure the same as or different from that of the first housing 721. This is not limited in this application.

As shown in FIG. 9a to FIG. 10c, in an implementation, the first housing 721 includes a middle frame 724 and a rear cover 725. The middle frame 724 includes a bottom plate 7242 and an outer frame 7241. The display screen 71 and the rear cover 725 are respectively mounted on two sides (namely, upper and lower sides in FIG. 9a and FIG. 9b) of the outer frame 7241 in the third direction Z, and the bottom plate 7242 is located between the display screen 71 and the rear cover 725.

A hollowed-out portion 7250 is disposed on the rear cover 725 of the electronic device body 7, and the hinge mechanism 100 and the stand 81 are disposed on the bottom plate 7242 of the middle frame 724, and are correspondingly disposed in the hollowed-out portion 7250 on the rear cover 725 in the third direction Z. Alternatively, it may be understood that a partial region on the rear cover 725 is hollowed out to accommodate the stand 81 and the hinge mechanism 100 that are mounted on the bottom plate 7242 of the middle frame 724.

It should be noted that a specific structure of the stand 81 is not limited. In an implementation, the stand 81 includes a stand body 811 and a mounting member 812. The stand body 811 is set to be of a plate-like structure. The mounting member 812 is connected to the stand body 811, and is located, in the third direction Z, on a side that is of the stand body 811 and that faces the display screen 71. The hinge mechanism 100 is mounted on the mounting member 812 of the stand 81. The stand body 811 is a structure configured to support the electronic device body 7, and the mounting member 812 is mainly configured to be connected to the hinge mechanism 100. In the third direction Z, both the hinge mechanism 100 and the mounting member 812 are located on the side that is of the stand body 811 and that faces the display screen 71. In this structure, there is a height difference between the stand body 811 and the hinge mechanism 100, making it convenient to hide the hinge mechanism 100 in the electronic device body 7. In an implementation, when the stand 81 is in the stowed state, the stand body 811 is integrally built in the hollowed-out portion 7250 on the rear cover 725. Alternatively, it may be understood that in the third direction Z, the stand body 811 is integrally located in the hollowed-out portion 7250. When the stand 81 is in the open state, at least a partial structure of the stand body 811 is separated from the hollowed-out portion 7250, and protrudes from an outer surface of the electronic device body 7, that is, the stand body 811 and the electronic device body 7 are opened relative to each other. In this structure, when the stand 81 is in the stowed state, the stand body 811 may be built in the electronic device body 7, and does not protrude from the electronic device body 7. Therefore, the stand 81 does not cause an increase in a local thickness of the electronic device 200, making the electronic device 200 thinner and more lightweight.

As shown in FIG. 9a, in an implementation, when the stand 81 is in the closed state, in the first direction X, the stand 81 is located between two outer frames 7241 of the middle frame 724, and an end that is of the stand 81 and that is away from the first axis Q1 fits with an outer frame 7241 on the side (the right side in FIG. 9a) through a gap. In another alternative implementation, the stand 81 may further extend to the outer frame 7241. For example, a part of an outer frame 7241 on the right side in FIG. 9a is hollowed out to accommodate the stand 81. This is not limited in this application.

As shown in FIG. 9a to FIG. 10c, in an implementation, the electronic device body 7 further includes a cover plate 82 disposed in the hollowed-out portion 7250 on the rear cover 725. The cover plate 82 is disposed, in the first direction X, on a side that is of the stand 81 and that faces the hinge mechanism 100, and is connected to the stand body 811, so that the cover plate 82 and the stand 81 form a stand structure 8. When the stand 81 is in the stowed state, a projection of the stand structure 8 on the display screen 71 in the third direction Z coincides with a projection of the hollowed-out portion 7250 on the display screen 71 in the third direction Z. Alternatively, it may be understood that the cover plate 82 is disposed over the hinge mechanism 100, to hide the hinge mechanism 100 in the electronic device body 7, so that the user cannot directly see the hinge mechanism 100 from an appearance. In addition, the stand structure 8 formed by the cover plate 82 and the stand 81 is connected and laid in the hollowed-out portion 7250 on the rear cover 725. When the stand 81 is in the stowed state, the stand structure 8 completely coincides with the hollowed-out portion 7250 in the third direction Z, and a periphery of the stand structure 8 is connected to a physical structure of the rear cover 725, so that the display screen 71, the housing, and the stand 81 in the electronic device 200 form a closed structure, and the user cannot observe an internal component of the electronic device 200. A person skilled in the art may understand that the cover plate 82 is used to shield and protect the hinge mechanism 100. The cover plate 82 may be separately disposed, or may be integrally formed with the rear cover 725. This is not limited in this application. In an example scenario, when the cover plate 82 and the rear cover 725 are integrally formed, a partial structure of the rear cover 725 may be reused as the cover plate, and the hollowed-out portion 7250 on the rear cover 725 may be used only to accommodate the stand 81.

In an implementation, in the third direction Z, a surface on a side that is of the cover plate 82 and that is away from the display screen 71 is located on a same plane as a surface on a side that is of the rear cover 725 and that is away from the display screen 71. When the stand 81 is in the stowed state, a surface on a side that is of the stand 81 and that is away from the display screen 71 is also located on a same plane as the surface on the side that is of the rear cover 725 and that is away from the display screen 71. Alternatively, it may be understood that in perspectives in FIG. 9a to FIG. 10c, when the stand 81 is in the stowed state, an upper surface of the stand body 811 is flush with an upper surface of the rear cover 725, to ensure flatness and smoothness of an outer surface of the electronic device 200, so that the electronic device 200 has an even thickness at each position, is simple and aesthetically pleasing, and is used with a good hand feeling. In another alternative implementation, an upper surface of the stand structure 8 may not be flush with the upper surface of the rear cover 725. This is not limited in this application.

It should be noted that for an aesthetically pleasing appearance of the electronic device, shapes of the stand 81 and the cover plate 82 may be designed, so that the rear cover 725 of the electronic device presents a specific appearance. The stand 81 and the cover plate 82 may fit with each other through a gap, or may engage or fit with each other through any other shaping components. This is not limited in this application. For example, as shown in FIG. 7, in an implementation, a beam 726 is disposed between the stand 81 and the cover plate 82, so that the stand 81, the cover plate 82, and the beam 726 present an H-shaped structure, to implement a simple and aesthetically pleasing appearance. The beam 726 and the rear cover 725 may be integrally formed, or may be of a split structure. This is not limited in this application. In another alternative implementation, the beam 726 may not be disposed between the stand 81 and the cover plate 82, and the stand 81 and the cover plate 82 may alternatively be designed with other appearances. This may be specifically set as required.

A person skilled in the art may understand that when the stand 81 is in the stowed state, the stand 81 may seal the hollowed-out portion 7250 on the rear cover 725 together with the cover plate 82. However, when the stand 81 is in the open state, an opening is formed between the stand body 811 and the electronic device body 7, the hollowed-out portion 7250 on the rear cover 725 is exposed, and an internal structure of the electronic device 200 is exposed. To resolve this problem, some shielding structures may be disposed in the electronic device body 7.

As shown in FIG. 8 to FIG. 10c, in an implementation, a stepped structure 9 is disposed on the bottom plate 7242 of the middle frame 724. The stepped structure 9 is connected to the bottom plate 7242, and is located, in the third direction Z, on a side that is of the bottom plate 7242 and that faces away from the display screen 71. The stand 81 is disposed on the bottom plate 7242 of the middle frame 724 through the stepped structure 9. The stepped structure 9 includes a top surface 91 and a side surface 92 that are perpendicular to each other. The side surface 92 extends in the third direction Z, and the top surface 91 is connected to an end that is of the side surface 92 and that is away from the display screen 71 in the third direction Z. When the stand 81 is in the stowed state, the top surface 91 is opposite to the stand body 811 of the stand 81. When the stand 81 is in the open state, an opening is formed between the stand body 811 and the top surface 91 of the stepped structure 9. Alternatively, it may be understood that the stepped structure 9 is disposed between the stand body 811 and the bottom plate 7242 of the middle frame 724, and the stepped structure 9 has a specific thickness. When the stand body 811 rotates and is opened, the top surface 91 of the stepped structure 9 may shield an opening between the stand body 811 and the electronic device body 7, so that the user sees the top surface 91 of the stepped structure 9 instead of another electronic component in the electronic device 200. This improves electronic aesthetics and can protect the electronic component in the electronic device 200.

It should be noted that a specific structure of the stepped structure 9 is not limited in this application, and may be a straight plate-like structure, an "L-shaped" plate-like structure, or the like. The stepped structure 9 and the bottom plate 7242 of the middle frame 724 may be integrally formed, or a split design may be used, and the stepped structure 9 is mounted on the bottom plate 7242. This is not limited in this application.

Further, the stand 81 is connected to the hinge structure 100. A connection position between the stand 81 and the hinge mechanism 100 is connected and transitioned through a structure such as a connecting piece, and cannot be shielded through the stepped structure 9. When the stand 81 is opened, the connection position between the hinge mechanism 100 and the stand 81 is still exposed, and the hinge mechanism 100 may be shielded by designing a shape of the mounting member 812 of the stand 81.

As shown in FIG. 8 to FIG. 10c, in an implementation, the mounting member 812 of the stand 81 is set to be of an arc-shaped structure. When the stand 81 is in the stowed state, the mounting member 812 is integrally located, in the first direction X, on a side that is of the side surface 92 of the stepped structure 9 and that faces the cover plate 82. When the stand 81 is in the open state, at least a partial structure of the mounting member 812 is located, in the first direction X, on a side that is of the side surface 92 of the stepped structure 9 and that faces away from the cover plate 82. Alternatively, it may be understood that the arc-shaped mounting member 812 is located in a gap between the stepped structure 9 and the hinge mechanism 100. When the stand 81 rotates, the arc-shaped structure rotates in the gap. When the stand body 811 is opened at a specific angle relative to the electronic device body 7, the arc-shaped structure is exposed with the stand body 811, shielding the gap between the stepped structure 9 and the hinge mechanism 100, and shielding a gap between the stand body 811 and the hinge mechanism 100, thereby implementing comprehensive shielding for the hinge mechanism 100.

A person skilled in the art may understand that the stand 81 rotates about the first axis Q1 relative to the electronic device body 7, and a position of the first axis Q1 is not limited.

As shown in FIG. 3a to FIG. 10c, in an implementation, the first axis Q1 is located on a surface that is of the stand structure 8 and that is away from the display screen 71 in the third direction Z, and is located at a joint between the cover plate 82 and the stand body 811. In a process in which the stand 81 rotates relative to the electronic device body 7, an upper surface of the stand body 811 and an upper surface of the cover plate 82 always fit with each other through a gap, so that the electronic device 200 has a simple and aesthetically pleasing appearance and a smooth plane transition. In another alternative implementation, the first axis Q1 may alternatively be located outside the surface of the stand structure 8, located outside the joint between the cover plate 82 and the stand body 811, or the like. This is not limited in this application.

The foregoing mainly describes the structure of the electronic device 200, to generally describe a fitting relationship between the stand 81 and the electronic device body 7 and a use scenario of the hinge mechanism 100 provided in this application. The following further describes a principle and a structure of the hinge mechanism 100 with reference to the accompanying drawings.

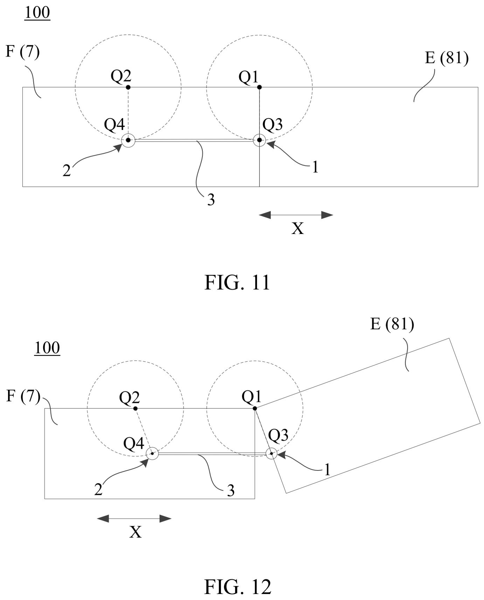

Refer to FIG. 11 and FIG. 12. FIG. 11 and FIG. 12 are diagrams of a principle structure of a hinge mechanism according to an embodiment of this application.

As shown in FIG. 11 and FIG. 12, the hinge mechanism 100 provided in this embodiment of this application may be configured to connect a first component E and a second component F, and the first component E is capable of rotating about the first axis Q1 relative to the second component F. In an implementation, the first component E is the stand 81, and the second component F is the electronic device body 7, to rotatably connect the electronic device body 7 and the stand 81 through the hinge mechanism 100. In another alternative implementation, the first component E may alternatively be the electronic device body 7, and the second component F may alternatively be the stand 81. This is not limited in this application. It should be understood that in the following, the first component E may refer to the stand 81, and the second component F may refer to the electronic device body 7. This is not repeatedly described.

The hinge mechanism 100 includes a first damping structure 1, a second damping structure 2, and a connecting piece 3. The first damping structure 1 is mounted on the first component E. The first damping structure 1 and the second damping structure 2 are spaced apart in the first direction X and are connected through the connecting piece 3. The first damping structure 1 is capable of rotating about the first axis Q1 relative to the second component F under driving of the first component E, and the second damping structure 2 is driven by the connecting piece 3 to rotate about a second axis Q2 relative to the second component F. Both the first axis Q1 and the second axis Q2 extend in the second direction Y.

Two damping structures are disposed in the hinge mechanism 100 provided in this embodiment of this application, and the two damping structures are linked through the connecting piece 3. When the first component E and the second component F rotate relative to each other, both the two damping structures provide damping forces, and the damping forces of the damping structures are superimposed together to support the second component F. For example, the stand 81 supports the electronic device body 7. The first damping structure 1 and the second damping structure 2 are disposed in the first direction X, the stand 81 rotates about the first axis Q1 relative to the electronic device body 7, the first axis Q1 extends in the second direction Y, and the first direction X and the second direction Y are perpendicular to each other. This may be understood as that an arrangement direction of the two damping structures is perpendicular to an axis direction in which the stand 81 rotates.

In this structure, the stand 81 is mounted only on the first damping structure 1, and a width of the stand 81 (a size of the stand 81 in the second direction Y) is related only to a size of the first damping structure 1 in the second direction Y. However, a support force for supporting the electronic device body 7 by the stand 81 is obtained by superimposing damping forces of the first damping structure 1 and the second damping structure 2. When the damping force of the first damping structure 1 is insufficient, the second damping structure 2 may compensate. Therefore, the size of the first damping structure 1 can be reduced in the second direction Y, and the width d of the stand 81 can be correspondingly reduced. In addition, the second damping structure 2 may be designed with a large size, to provide a sufficient damping force, so as to ensure stability when the stand 81 supports the electronic device body 7.

It may be learned that the hinge mechanism 100 provided in this embodiment of this application can provide a large damping force when the stand 81 of the electronic device 200 has a small width, thereby achieving a balance between stability of support by and a miniaturization design of the stand 81.

A person skilled in the art may understand that specific structures of the first damping structure 1, the second damping structure 2, and the connecting piece 3 are not limited. With reference to the accompanying drawings, the following describes structures that may be used.

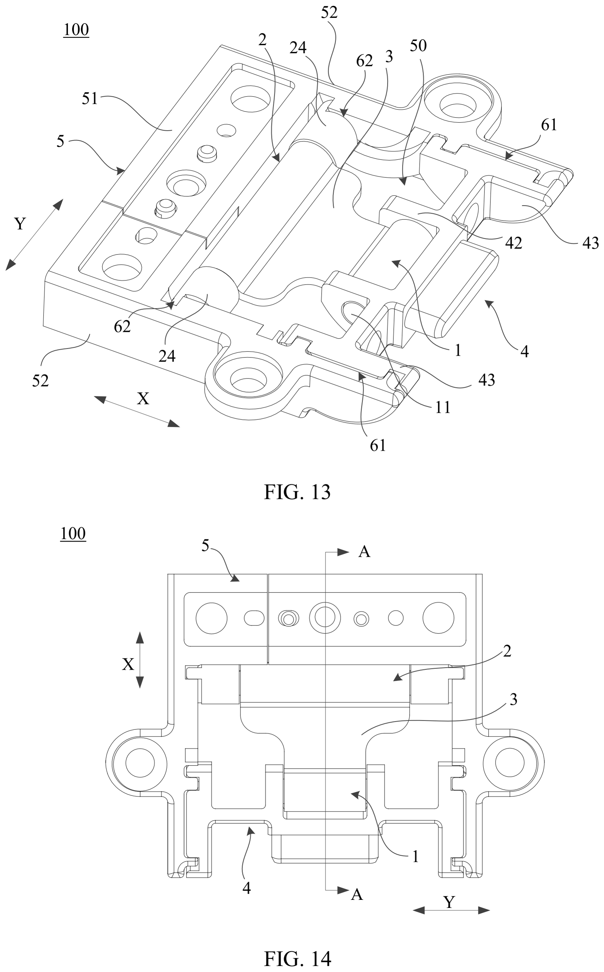

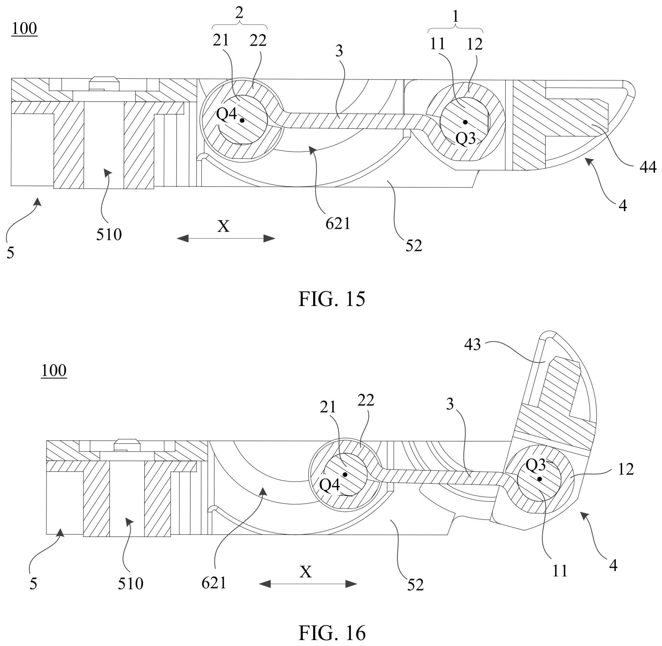

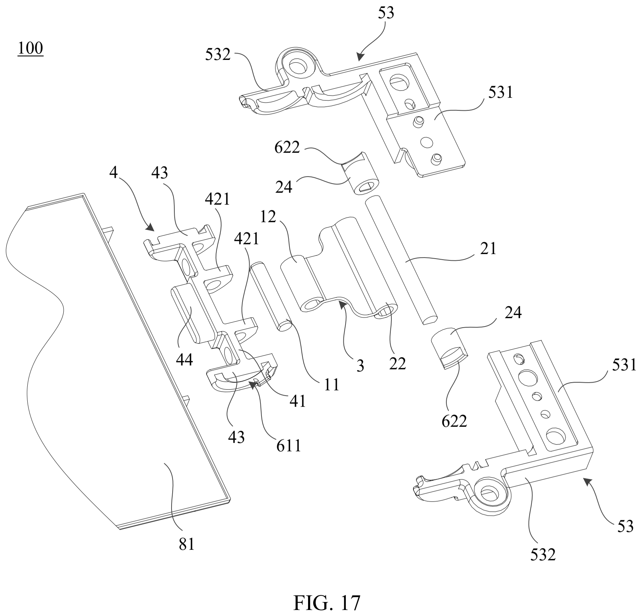

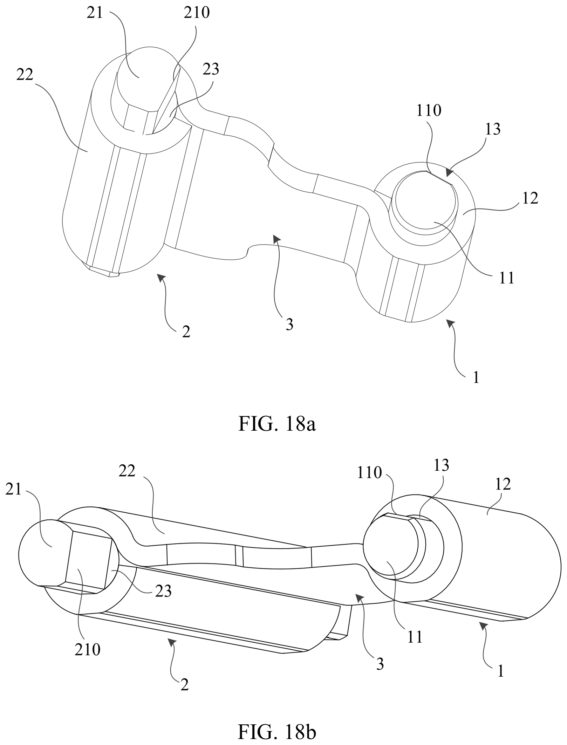

Refer to FIG. 13 to FIG. 18b. FIG. 13 is a diagram of a three-dimensional structure of a hinge mechanism according to an embodiment of this application; FIG. 14 is a diagram of a top-view structure of a hinge mechanism according to an embodiment of this application; FIG. 15 is a diagram of a cross-section structure in a direction A-A in FIG. 14; FIG. 16 is a diagram of a cross-section structure of a hinge mechanism in another state in a direction A-A in FIG. 14 according to an embodiment of this application; FIG. 17 is a diagram of an exploded structure of a hinge mechanism according to an embodiment of this application; FIG. 18a is a diagram of a connection structure between a first damping structure, a second damping structure, and a connecting piece in a hinge mechanism according to an embodiment of this application; and FIG. 18b is a diagram of a connection structure between a first damping structure, a second damping structure, and a connecting piece in a hinge mechanism at another angle according to an embodiment of this application.

As shown in FIG. 11 to FIG. 18b, in an implementation, the first damping structure 1 includes a first rotating shaft 11 and a first sleeve 12, and the first rotating shaft 11 is sleeved in the first sleeve 12, and is capable of rotating about a third axis Q3 relative to the first sleeve 12. The second damping structure 2 includes a second rotating shaft 21 and a second sleeve 22, and the second rotating shaft 21 is sleeved in the second sleeve 22, and is capable of rotating about a fourth axis Q4 relative to the second sleeve 22. Both the third axis Q3 and the fourth axis Q4 extend in the second direction Y. Both the first sleeve 12 and the second sleeve 22 are connected to the connecting piece 3 and are fastened relative to the connecting piece 3, to connect the first damping structure 1 and the second damping structure 2 through the connecting piece 3.

The first rotating shaft 11 is mounted on the first component E, that is, the stand 81 of the electronic device 200 is connected to the first rotating shaft 11, and is mounted on the electronic device 200 through the first rotating shaft 11. When the stand 81 needs to be used, the user may manually rotate the stand 81, the stand 81 drives the first rotating shaft 11 to rotate in the first sleeve 12 relative to the first sleeve 12, and the damping force of the first damping structure 1 is generated due to friction between the first rotating shaft 11 and the first sleeve 12. In addition, the first rotating shaft 11 and the first sleeve 12 rotate about the first axis Q1, the second rotating shaft 21 and the second sleeve 22 are driven to rotate about the second rotating shaft 21, the second rotating shaft 21 rotates in the second sleeve 22 relative to the second sleeve 22, and the damping force of the second damping structure 2 is generated due to friction between the second rotating shaft 21 and the second sleeve 22. Both the first sleeve 12 and the second sleeve 22 are connected to the connecting piece 3 and are fastened relative to the connecting piece 3, to connect the first damping structure 1 and the second damping structure 2 through the connecting piece 3.

The first axis Q1 is an axis about which the first damping structure 1 rotates relative to the second component F, and is an axis about which the first component E rotates relative to the second component F, namely, an axis about which the stand 81 rotates relative to the electronic device body 7. The second axis Q2 is an axis about which the second damping structure 2 rotates relative to the second component F. The first axis Q1 and the second axis Q2 are parallel to each other, and may coincide or may not coincide. This is not limited in this application. The third axis Q3 is an axis about which the first rotating shaft 11 rotates relative to the first sleeve 12, and is an axis center of the first rotating shaft 11. The fourth axis Q4 is an axis about which the second rotating shaft 21 rotates relative to the second sleeve 22, and is an axis center of the second rotating shaft 21. Because the first axis Q1 and the second axis Q2 are parallel, and the first sleeve 12 and the second sleeve 22 are connected through the connecting piece 3, the third axis Q3 and the fourth axis Q4 are parallel to each other and both extend in the second direction Y.

In an implementation, all of the first axis Q1, the second axis Q2, the third axis Q3, and the fourth axis Q4 are spaced apart. A distance between the first axis Q1 and the second axis Q2 is equal to a distance between the third axis Q3 and the fourth axis Q4, and a distance between the first axis Q1 and the third axis Q3 is equal to a distance between the second axis Q2 and the fourth axis Q4. Alternatively, it may be understood that on a plane perpendicular to the second direction Y, the first axis Q1, the second axis Q2, the third axis Q3, and the fourth axis Q4 form a parallelogram structure, and in the parallelogram structure, an edge between the first axis Q1 and the second axis Q2 is fixed, an edge between the first axis Q1 and the third axis Q3 rotates, an edge between the second axis Q2 and the fourth axis Q4 rotates, and an edge between the third axis Q3 and the fourth axis Q4 moves and is always parallel to the edge between the first axis Q1 and the second axis Q2, that is, the second component F, the first damping structure 1, the second damping structure 2, and the connecting piece 3 form a four-bar linkage structure.

In another alternative implementation, all the axes may alternatively be set to another position relationship. For example, the first axis Q1 may coincide with the second axis Q2. On the plane perpendicular to the second direction Y, the first axis Q1 (the second axis Q2), the third axis Q3, and the fourth axis Q4 form a triangular structure, and the triangular structure is capable of integrally rotating about the first axis Q1. In this case, a distance between the first axis Q1 (the second axis Q2) and the third axis Q3 and a distance between the first axis Q1 (the second axis Q2) and the fourth axis Q4 may be equal or unequal. This is not limited in this application.

As described above, some limiting structures may be disposed in the electronic device 200, to limit an angle at which the stand 81 is opened relative to the electronic device body 7, or remind the user of an optimal angle at which the stand 81 supports the electronic device body 7. These limiting structures may be disposed in the hinge mechanism 100, and more specifically, may be disposed on the damping structure, and limiting is performed by using a shape of the damping structure.

As shown in FIG. 15 to FIG. 18b, in an implementation, a first limiting portion 13 is disposed in the first sleeve 12, a partial outer surface of the first rotating shaft 11 in a circumferential direction of the first rotating shaft 11 is set to a flat surface, the first limiting portion 13 is of an elastic structure (for example, a spring plate, which is not limited in this application), and when the first rotating shaft 11 rotates to a first position (a position shown in FIG. 18a and FIG. 18b) relative to the first sleeve 12, the first limiting portion 13 and the first rotating shaft 11 fit with each other through the flat surface. Alternatively, it may be understood that an elastic first limiting portion 13 is disposed between the first rotating shaft 11 and the first sleeve 12, and in a circumferential direction of the first rotating shaft 11, a partial outer surface of the first rotating shaft 11 is a curved surface, and the other partial outer surface is a flat surface. When the first rotating shaft 11 rotates relative to the first sleeve 12, both the curved surface and the flat surface may fit with the first limiting portion 13. When the first rotating shaft 11 fits with the first limiting portion 13 through the curved surface, the first limiting portion 13 is compressed by the first rotating shaft 11 into a sheet-like structure close to an inner wall surface of the first sleeve 12. In this case, a friction force between the first rotating shaft 11 and the first sleeve 12 is small, the damping force of the first damping structure 1 is small, and the user smoothly rotates the stand 81 with low effort. When the first rotating shaft 11 fits with the first limiting portion 13 through the flat surface, the first limiting portion 13 rebounds to a shape having a flat surface. In this case, a friction force between the first rotating shaft 11 and the first sleeve 12 is large, the damping force of the first damping structure 1 is large, and the user laboriously performs rotation. The first position is a limiting position of the first damping structure 1. There may be one or more first positions, and each first position corresponds to a specific angle. For example, the first damping structure 1 may be set as follows: At a specific angle (for example, the stand 81 is opened at 60°, 70°, or 75° relative to the electronic device body 7, which is not specifically limited), the first rotating shaft 11 fits with the first limiting portion 13 through the flat surface, the user rotates the stand 81 from smoothly to laboriously, and the electronic device 200 is placed on the desktop at the specific angle for use, to achieve stable support and good user experience.

In another alternative implementation, the first limiting portion 13 may alternatively use another structure. For example, a groove may be disposed on an inner wall of the first sleeve 12, and the first limiting portion 13 may be an elastic part disposed in the groove. When the curved surface of the first rotating shaft 11 rotates to be opposite to the groove on the inner wall of the first sleeve 12, the curved surface compresses the elastic part into the groove. A friction force between the first rotating shaft 11 and the first sleeve 12 is small, and the damping force of the first damping structure 1 is small. When the flat surface of the first rotating shaft 11 is opposite to the groove on the inner wall of the first sleeve 12 (that is, the first rotating shaft 11 rotates to the first position relative to the first sleeve 12), the elastic part ejects from the groove, protrudes from an inner wall surface of the first sleeve 12, and presses against the flat surface of the first rotating shaft 11. A friction force between the first rotating shaft 11 and the first sleeve 12 is large, and the damping force of the first damping structure 1 is large. The elastic part may be a structure such as a spring plate having elasticity, or may be an elastic structure including a spring and a bump. For example, the bump and the spring may be mounted in the groove of the first sleeve 12, one end of the spring is connected to a bottom of the groove, the other end is connected to the bump, and the bump fits with the first rotating shaft 11.

In an implementation, a second limiting portion 23 is disposed in the second sleeve 22, a partial outer surface of the second rotating shaft 21 in a circumferential direction of the second rotating shaft 21 is set to a flat surface, the second limiting portion 23 is of an elastic structure, and when the second rotating shaft 21 rotates to a second position relative to the second sleeve 22, the second limiting portion 23 and the second rotating shaft 21 fit with each other through the flat surface. The second position is a limiting position of the second damping structure 2, namely, a position shown in FIG. 18a and FIG. 18b. A function and a working principle of the second limiting portion 23 are the same as those of the first limiting portion 13. Details are not described herein. A specific structure of the second limiting portion 23 is not limited in this application either. For a design, refer to the first limiting portion 13.

A person skilled in the art may understand that a limiting portion may be disposed only in one of the first damping structure 1 and the second damping structure 2, and no limiting portion is disposed in the other one, or a limiting portion is disposed in each of the two damping structures. This is not limited in this application.

In an implementation, a plurality of limiting portions may be disposed in the first damping structure 1 or the second damping structure 2, and each limiting portion corresponds to a different specified angle. A specific quantity of limiting portions in each damping structure is not limited, and may be 1, 2, 3, or more. In an example scenario, two first limiting portions 13 may be disposed in the first damping structure 1. When the stand 81 is opened at 45° relative to the electronic device body 7, the first rotating shaft 11 fits with one first limiting portion 13 through the flat surface. When the stand 81 continues to be rotated until the stand 81 is opened at 60° relative to the electronic device body 7, the first rotating shaft 11 fits with the other first limiting portion 13 through the flat surface. At each of the two specific angles, the damping force of the hinge mechanism 100 is large, and the stand 81 may stably support the electronic device body 7. The user may make a selection as required based on a scenario such as a height of the user and a height of the desktop. In an alternative implementation, limiting portions may be separately disposed in the first damping structure 1 and the second damping structure 2, and the limiting portions in the first damping structure 1 and the second damping structure 2 may correspond to different angles and use scenarios. This is not limited in this application.

A person skilled in the art may understand that a specific structure of the connecting piece 3 is not limited. The connecting piece 3 is fastened to the first sleeve 12 and the second sleeve 22. The first sleeve 12 and the connecting piece 3 may be integrally formed, or may be of a split structure. The second sleeve 22 and the connecting piece 3 may be integrally formed, or may be of a split structure. This is not limited in this application. As shown in FIG. 13 to FIG. 18b, in an implementation, the connecting piece 3 is set to a connecting rod, and two ends of the connecting rod respectively form the first sleeve 12 and the second sleeve 22, that is, each of the first sleeve 12 and the second sleeve 22 is integrally formed with the connecting piece 3. A structure is simple and easy to process.

A person skilled in the art may understand that the hinge mechanism 100 needs to be mounted on the second component F and connected to the first component E, so that the first component E and the second component F can be rotatably connected. Some structures for connection and fastening may be disposed between the hinge mechanism 100 and each of the second component F and the first component E. A manner of connecting the hinge mechanism 100 to the second component F and the first component E is not limited in this application. With reference to the accompanying drawings, the following describes, by using an example, a structure that may be used.

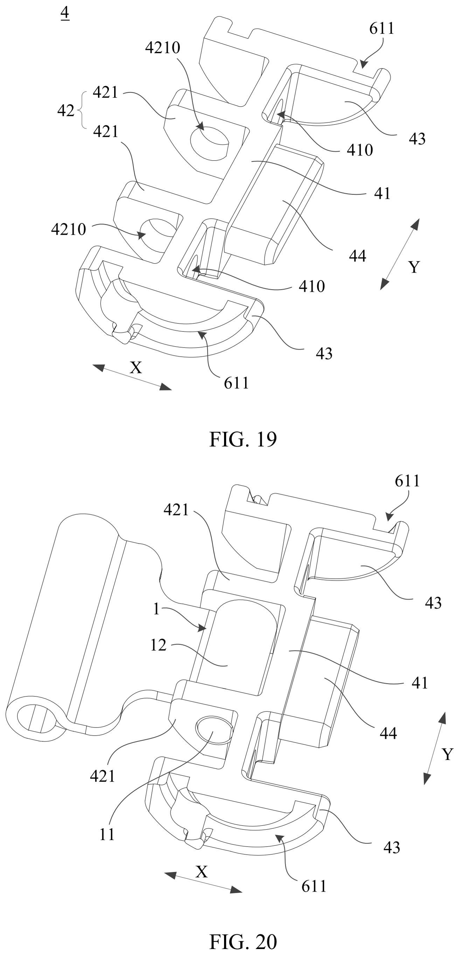

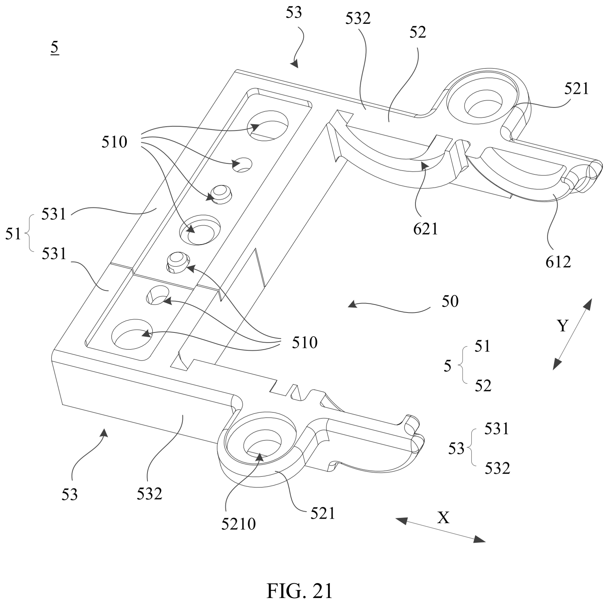

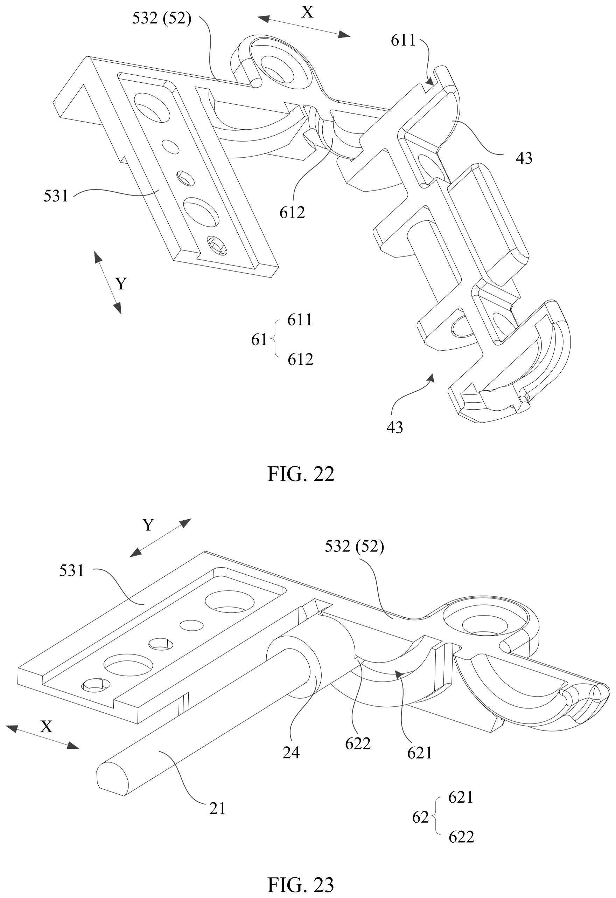

Refer to FIG. 19 to FIG. 23. FIG. 19 is a diagram of a structure of a first fastener in a hinge mechanism according to an embodiment of this application; FIG. 20 is a diagram of a connection structure between a first fastener and a first damping structure in a hinge mechanism according to an embodiment of this application; FIG. 21 is a diagram of a structure of a second fastener in a hinge mechanism according to an embodiment of this application; FIG. 22 is a diagram of a fitting relationship between a first fastener and a second fastener in a hinge mechanism according to an embodiment of this application; and FIG. 23 is a diagram of a fitting relationship between a second fastener and a second damping structure in a hinge mechanism according to an embodiment of this application.

As shown in FIG. 13 to FIG. 23, in an implementation, the hinge mechanism 100 further includes a first fastener 4 and a second fastener 5. The first fastener 4 is fastened to the first component E, the first rotating shaft 11 in the first damping structure 1 is mounted on the first fastener 4, and the first damping structure 1 is capable of being mounted on the first component E through the first fastener 4. The second fastener 5 is fastened to the second component F, the second rotating shaft 21 in the second damping structure 2 is mounted on the second fastener 5, and the second damping structure 2 is capable of being mounted on the second component F through the second fastener 5.

Further, the first fastener 4 is capable of rotating about the first axis Q1 relative to the second fastener 5, so that the first component E is capable of rotating about the first axis Q1 relative to the second component F. For example, the second fastener 5 is fastened to the electronic device body 7, and the stand 81 is fastened to the first fastener 4, and is rotatably connected to the second fastener 5 through the first fastener 4, to be further rotatably connected to the electronic device body 7. When the user rotates the stand 81, the stand 81 drives the first fastener 4 to rotate relative to the second fastener 5. Because the second fastener 5 is fastened relative to the electronic device body 7, the first fastener 4 rotates relative to the electronic device body 7, and the stand 81 rotates relative to the electronic device body 7. In some alternative implementations, the first fastener 4 may not be disposed in the hinge mechanism 100. For example, the first component E may be directly mounted on the first rotating shaft 11. The second fastener 5 may not be disposed in the hinge mechanism 100. For example, the second damping structure 2 may be directly mounted on the second component F. This is not limited in this application.

It should be noted that specific shapes of the first fastener 4 and the second fastener 5 are not limited. As shown in FIG. 13, FIG. 17, and FIG. 21 to FIG. 23, in an implementation, the second fastener 5 includes a base body 51 extending in the second direction Y and two extension arms 52 respectively connected to two ends of the base body 51 in the second direction Y. Each of the two extension arms 52 extends in the first direction X and protrudes from the base body 51 toward a same side, so that mounting space 50 is enclosed between the two extension arms 52 and the base body 51. All of the first damping structure 1, the second damping structure 2, the connecting piece 3, and the first fastener 4 are mounted in the mounting space 50. In the first direction X, the second damping structure 2 is located on a side that is of the first damping structure 1 and that is close to the base body 51, and the first fastener 4 is located on a side that is of the first damping structure 1 and that is away from the base body 51. Alternatively, it may be understood that the second fastener 5 is integrally of a U-shaped structure, the second damping structure 2, the first damping structure 1, and the first fastener 4 are sequentially arranged in the U-shaped structure in the first direction X, and the second damping structure 2 is close to the base body 51 of the second fastener 5.

Each part of the second fastener 5 in an extension direction of the second fastener 5 may be fastened to the second component F. In an implementation, both the base body 51 and each extension arm 52 of the second fastener 5 may be fastened to the second component F. A plurality of fastening holes 510 are disposed on the base body 51, and the base body 51 may be fastened to the second component F through a fastener such as a screw or a bolt. An extension platform 521 protruding from the extension arm 52 is disposed on the extension arm 52, a fastening hole 5210 is disposed on the extension platform 521, and the extension arm 52 may be fastened to the second component F through a fastener such as a screw or a bolt. A person skilled in the art may understand that a quantity of fastening holes 510 on the base body 51 is not limited, and a quantity of extension platforms 521 on the extension arm 52 and a quantity of fastening holes 5210 on the extension platform 521 are not limited, and may be set as required.

A person skilled in the art may understand that the second fastener 5 may be of an integrated structure, or may be of a split structure. In an implementation, the second fastener 5 has two fastening portions 53. Each of the two fastening portions 53 includes a first part 531 extending in the second direction Y and a second part 532 extending in the first direction X. The first part 531 and the second part 532 are connected. First parts 531 of the two fastening portions 53 are connected and fastened to form the base body 51 of the second fastener 5. Second parts 532 of both of the two fastening portions 53 respectively form the two extension arms 52 of the second fastener 5. Alternatively, it may be understood that the second fastener 5 is split into two fastening portions 53 from the base body 51, and each fastening portion 53 includes one extension arm 52 and a part of the base body 51. The two fastening portions 53 may be fastened through welding, bolting, bonding, or riveting, or in another manner. This is not specifically limited. In an implementation, fitting surfaces of the two fastening portions 53 are set to two inverted L-shaped structures, and the fastener penetrates through the fastening hole 510 at a corresponding position on the base body 51, and may penetrate through both the two fastening portions 53, to securely combine the two fastening portions 53.

As shown in FIG. 13, FIG. 17, FIG. 19, FIG. 20, and FIG. 22, in an implementation, the first fastener 4 includes a base 41, and the base 41 is fastened to the first component E. A specific manner of connecting the base 41 to the first component E is described below with reference to a structure of the stand 81. Details are not described herein.

In an implementation, a mounting portion 42 is further disposed on the first fastener 4. The first rotating shaft 11 is mounted on the mounting portion 42, the mounting portion 42 is connected to the base 41, and protrudes from the base 41 in the first direction X toward a side on which the first damping structure 1 is located, and the first rotating shaft 11 in the first damping structure 1 is mounted on the mounting portion 42, to connect the first component E and the first rotating shaft 11 through the mounting portion 42.

It should be noted that a specific structure of the mounting portion 42 is not limited. In an implementation, the mounting portion 42 includes two bosses 421 spaced apart in the second direction Y, the first damping structure 1 is located between the two bosses 421, a through-hole is disposed on each of the two bosses 421, and two ends of the first rotating shaft 11 in the first damping structure 1 protrude from the first sleeve 12, and respectively penetrate through through-holes on the two bosses 421. With reference to the foregoing descriptions, it may be learned that the first rotating shaft 11 is capable of rotating with the first fastener 4 relative to the second fastener 5, and the first rotating shaft 11 and the first fastener 4 only need to be fastened relative to each other on the plane perpendicular to the second direction Y. The first rotating shaft 11 is capable of rotating about the third axis Q3 in the through-holes on the two bosses 421 relative to the first fastener 4, or may be completely fastened to the first fastener 4. This is not limited in this application. In an implementation, the two ends of the first rotating shaft 11 are fastened to the two bosses 421, that is, the first rotating shaft 11 is completely fastened to the first fastener 4, to prevent the first rotating shaft 11 from sliding in the first sleeve 12 and the through-hole on the boss 421. A connection is more reliable, and a damping force of the first damping structure 1 can be better transferred to the first component E. A manner of fastening the first rotating shaft 11 and the boss 421 is not limited, and the first rotating shaft 11 and the boss 421 may be fastened through bonding, welding, or structural limiting, or in another manner. In an implementation, a partial outer circumferential surface of the first rotating shaft 11 may be set to a flat surface, and a corresponding position on the inner wall surface of the through-hole 4210 on each boss 421 is set to a flat surface. The first rotating shaft 11 and each boss 421 fit with each other through the flat surface, to limit relative rotation between the first rotating shaft 11 and the boss 421.

It should be noted that a manner in which the first fastener 4 rotates relative to the second fastener 5 is not limited. For example, a connecting shaft may be disposed between the first fastener 4 and the second fastener 5, and the connecting shaft rotates about the first axis Q1 relative to the second fastener 5, so that the first fastener 4 is capable of rotating relative to the second fastener 5. In an implementation, the first fastener 4 is slidably connected to the second fastener 5, so that the first fastener 4 is capable of rotating about the first axis Q1 relative to the second fastener 5, and the first damping structure 1 is capable of rotating relative to the second fastener 5 under driving of the first fastener 4.

Specifically, in an implementation, the first fastener 4 further includes two rotating arms 43. The two rotating arms 43 are disposed at two ends of the base 41 in the second direction Y, and are respectively connected to the two ends of the base 41. In addition, the two rotating arms 43 are in a one-to-one correspondence with the two extension arms 52 of the second fastener 5, and each of the two rotating arms 43 is slidably connected to a corresponding extension arm 52 through a first sliding structure 61, so that the first fastener 4 is capable of rotating about the first axis Q1 relative to the second fastener 5. The first sliding structure 61 includes an arc-shaped sliding groove 611 and an arc-shaped slider 612 that are slidably connected to each other. One of the arc-shaped sliding groove 611 and the arc-shaped slider 612 in the first sliding structure 61 is disposed on the rotating arm 43 of the first fastener 4, and the other is disposed on the extension arm 52 of the second fastener 5. The arc-shaped slider 612 slides along an arc-shaped trajectory in the arc-shaped sliding groove 611, the first axis Q1 passes through a circle center of the arc-shaped trajectory, and the first fastener 4 is capable of rotating about the first axis Q1 relative to the second fastener 5. Therefore, the first component E and the first damping structure 1 are capable of rotating about the first axis Q1 relative to the second component F.

In an implementation, the arc-shaped sliding groove 611 in the first sliding structure 61 is disposed on the rotating arm 43 of the first fastener 4, and the arc-shaped slider 612 is disposed on the extension arm 52 of the second fastener 5. In an alternative implementation, the arc-shaped sliding groove 611 in the first sliding structure 61 may alternatively be disposed on the extension arm 52 of the second fastener 5, and the arc-shaped slider 612 may alternatively be disposed on the rotating arm 43 of the first fastener 4. This is not limited in this application.

A person skilled in the art may understand that the second rotating shaft 21 is mounted on the second fastener 5. If the second rotating shaft 21 is capable of rotating relative to the second fastener 5, the second damping structure 2 is capable of rotating relative to the second component F. Similarly, a manner in which the second rotating shaft 21 rotates relative to the second fastener 5 is not limited. In an implementation, the second damping structure 2 is slidably connected to the second fastener 5, so that the second damping structure 2 is capable of rotating about the second axis Q2 relative to the second fastener 5.

Specifically, as shown in FIG. 17 and FIG. 23, in an implementation, the second damping structure 2 further includes two shaft sleeves 24 spaced apart in the second direction Y, and the two shaft sleeves 24 are respectively sleeved at two ends of the second rotating shaft 21. The two shaft sleeves 24 are in a one-to-one correspondence with the two extension arms 52 of the second fastener 5, and each of the two shaft sleeves 24 is slidably connected to a corresponding extension arm 52 through a second sliding structure 62, so that the second damping structure 2 is capable of rotating about the second axis Q2 relative to the second fastener 5. The second sliding structure 62 includes an arc-shaped slider 622 and an arc-shaped sliding groove 621 that are slidably connected to each other. One of the arc-shaped slider 622 and the arc-shaped sliding groove 621 in the second sliding structure 62 is disposed on the shaft sleeve 24, and the other is disposed on the extension arm 52 of the second fastener 5. The arc-shaped slider 622 slides along an arc-shaped trajectory in the arc-shaped sliding groove 621, the second axis Q2 passes through a circle center of the arc-shaped trajectory, and the second rotating shaft 21 is capable of rotating about the second axis Q2 relative to the second fastener 5 through the shaft sleeve 24. Therefore, the second damping structure 2 is capable of rotating about the second axis Q2 relative to the second component F.

In an implementation, the arc-shaped slider 622 in the second sliding structure 62 is disposed on the shaft sleeve 24, and the arc-shaped sliding groove 621 is disposed on the extension arm 52 of the second fastener 5. In an alternative implementation, the arc-shaped slider 622 in the second sliding structure 62 may alternatively be disposed on the extension arm 52 of the second fastener 5, and the arc-shaped sliding groove 621 may alternatively be disposed on the shaft sleeve 24. This is not limited in this application.

The foregoing mainly describes a fitting relationship between the stand 81 and the electronic device body 7 in the electronic device 200 and a specific structure of the hinge mechanism 100. With reference to the accompanying drawings, the following describes a mounting manner between the hinge mechanism 100 and the stand 81 by using an example.

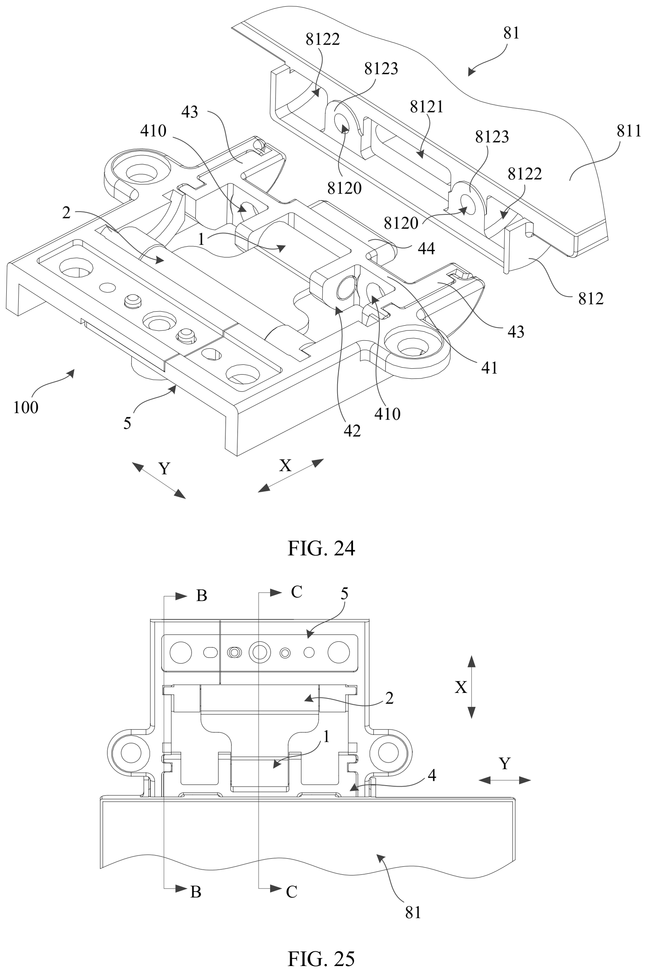

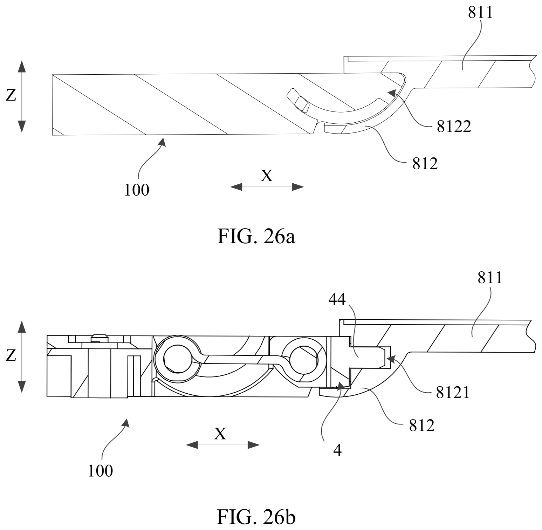

Refer to FIG. 24 to FIG. 26b. FIG. 24 is a diagram of exploded structures of a hinge mechanism and a stand according to an embodiment of this application; FIG. 25 is a diagram of a connection structure between a hinge mechanism and a stand according to an embodiment of this application; FIG. 26a is a sectional view in a direction B-B in FIG. 25; and FIG. 26b is a sectional view in a direction C-C in FIG. 25.

As shown in FIG. 24 to FIG. 26b, the mounting member 812 of the stand 81 is fastened to the base 41 of the first fastener 4 in the hinge mechanism 100, to mount the stand 81 on the hinge mechanism 100. Specifically, in an implementation, a through-hole 410 that penetrates through the base 41 in the first direction X is disposed on the base 41. A quantity of through-holes 410 is not limited, and may be 1, 2, 3, or the like. This may be specifically set as required. In an implementation, two through-holes 410 are disposed on the base 41, and the two through-holes 410 are respectively disposed on two sides of the mounting portion 42 in the second direction Y. Two connecting walls 8123 are disposed between the mounting member 812 of the stand 81 and the stand body 811, and each connecting wall 8123 connects the stand body 811 and the mounting member 812. The two connecting walls 8123 respectively correspond to the two through-holes 410 on the base 41, and a fastening hole 8120 is disposed on each mounting member 812. A fastener such as a screw or a bolt may be used to sequentially pass through the through-hole 410 on the base 41 and the fastening hole 8120 on the mounting members 812, to fasten the stand 81 to the first fastener 4 in the hinge mechanism 100. In another alternative implementation, the base 41 may alternatively be fastened to the stand 81 through bonding, welding, bolting, or riveting, or in another manner. This is not limited in this application.

A person skilled in the art may understand that when the user rotates the stand 81, torque is generated between the stand 81 and the hinge mechanism 100. If only a fastener is used to connect the stand 81 and the hinge mechanism 100, problems such as deformation of the stand 81 and looseness of the fastener may occur after the stand 81 is frequently used. To enhance connection reliability between the stand 81 and the hinge mechanism 100, some connection strengthening structures may be disposed between the stand 81 and the hinge mechanism 100. For example, a component such as a pin shaft may be disposed between the mounting member 812 and the base 41 to strengthen the connection. A specific form is not limited.

As shown in FIG. 24 to FIG. 26b, in an implementation, an accommodation groove is disposed in the mounting member 812, and a partial structure of the hinge mechanism 100 is located in the accommodation groove. A connection area between the stand 81 and the hinge mechanism 100 is increased to improve connection reliability between the stand 81 and the hinge mechanism 100. It should be noted that a specific shape and position of the accommodation groove in the mounting member 812 and a structure that fits with the accommodation groove in the hinge mechanism 100 are not limited in this application.

In an implementation, the mounting member 812 includes a first accommodation groove 8121, the first fastener 4 further includes a bump 44 connected to the base 41, and the bump 44 protrudes from the base 41 in the first direction X toward a side facing away from the first damping structure 1. The bump 44 may be built in the first accommodation groove 8121, to improve connection strength between the mounting member 812 and the first fastener 4. In an implementation, the mounting member 812 further includes two second accommodation grooves 8122, and the two second accommodation grooves 8122 are located on two sides of the first accommodation groove 8121 in the second direction Y, and respectively correspond to the two rotating arms 43 of the first fastener 4 in the first direction X. The two rotating arms 43 may be respectively accommodated in the two second accommodation grooves 8122. Specific forms of the first accommodation groove 8121 and the second accommodation groove 8122 are not limited. For example, the first accommodation groove 8121 may be formed by space between the two connecting walls 8123, and the second accommodation groove 8122 may be formed by space enclosed by each connecting wall 8123 and a sidewall of a mounting member 812 on a side on which the connecting wall 8123 is located.

Shapes of the first accommodation groove 8121 and the second accommodation groove 8122 are not limited. In an implementation, the bump 44 on the base 41 is a rectangular bump, and the first accommodation groove 8121 is set to a rectangular accommodation groove corresponding to a shape of the bump 44. In an implementation, the second accommodation groove 8122 is an arc-shaped groove, the rotating arm 43 on the base 41 is also set to be in an arc shape, and the arc-shaped rotating arm 43 may be clamped into the arc-shaped second accommodation groove 8122. In an implementation, an end that is of the second fastener 5 and that is connected to each rotating arm 43 is also set to an arc-shaped structure. When the stand 81 is in the stowed state, an end portion of the second fastener 5 may also be accommodated in the second accommodation groove 8122. When the stand 81 switches from the stowed state to the open state, the end portion of the second fastener 5 may be gradually separated from the second accommodation groove 8122. In another alternative implementation, the shape of the first accommodation groove 8121 may be inconsistent with that of the bump 44, and the shape of the second accommodation groove 8122 may also be inconsistent with that of the rotating arm 43. Details are not listed one by one in this application.

It is clear that a person skilled in the art may make various modifications and variations to this application without departing from the scope of this application. In this way, if these modifications and variations to this application fall within the scope of the claims of this application and their equivalent technologies, this application is intended to cover these modifications and variations.

## Claims

1. A hinge mechanism, configured to connect a first component and a second component, wherein the first component is rotatably connected to the second component about a first axis, the hinge mechanism comprises a first damping structure, a second damping structure, and a connecting piece, the first damping structure is mounted on the first component, and the first damping structure and the second damping structure are spaced apart in a first direction and are connected through the connecting piece; and
when the first damping structure rotates about the first axis relative to the second component under driving of the first component, the second damping structure is driven by the connecting piece to rotate about a second axis relative to the second component, wherein both the first axis and the second axis extend in a second direction, and the second direction is perpendicular to the first direction.

2. The hinge mechanism according to claim 1, wherein the first damping structure comprises a first rotating shaft and a first sleeve, and the first rotating shaft is sleeved in the first sleeve, and is capable of rotating about a third axis relative to the first sleeve; and the second damping structure comprises a second rotating shaft and a second sleeve, and the second rotating shaft is sleeved in the second sleeve, and is capable of rotating about a fourth axis relative to the second sleeve;
the first rotating shaft is mounted on the first component, and the first sleeve is mounted on the first component through the first rotating shaft; and both the first sleeve and the second sleeve are connected to the connecting piece and are fastened relative to the connecting piece, to connect the first damping structure and the second damping structure through the connecting piece; and
both the third axis and the fourth axis extend in the second direction, and all of the first axis, the second axis, the third axis, and the fourth axis are mutually spaced apart; and a distance between the first axis and the second axis is equal to a distance between the third axis and the fourth axis, and a distance between the first axis and the third axis is equal to a distance between the second axis and the fourth axis.

3. The hinge mechanism according to claim 2, wherein a first limiting portion is disposed in the first sleeve, a partial outer surface of the first rotating shaft in a circumferential direction of the first rotating shaft is set to a flat surface, the first limiting portion is of an elastic structure, and when the first rotating shaft rotates to a first position relative to the first sleeve, the first limiting portion and the first rotating shaft fit with each other through the flat surface; and
a second limiting portion is disposed in the second sleeve, a partial outer surface of the second rotating shaft in a circumferential direction of the second rotating shaft is set to a flat surface, the second limiting portion is of an elastic structure, and when the second rotating shaft rotates to a second position relative to the second sleeve, the second limiting portion and the second rotating shaft fit with each other through the flat surface.

4. The hinge mechanism according to claim 2 or 3, wherein the connecting piece is set to a connecting rod, and two ends of the connecting rod respectively form the first sleeve and the second sleeve.

5. The hinge mechanism according to any one of claims 2 to 4, wherein the hinge mechanism further comprises:
a first fastener, wherein the first fastener is fastened to the first component, the first rotating shaft in the first damping structure is mounted on the first fastener, and the first damping structure is capable of being mounted on the first component through the first fastener; and
a second fastener, wherein the second fastener is fastened to the second component, the second rotating shaft in the second damping structure is mounted on the second fastener, and the second damping structure is capable of being mounted on the second component through the second fastener, wherein
the first fastener is capable of rotating about the first axis relative to the second fastener, so that the first component is capable of rotating about the first axis relative to the second component.

6. The hinge mechanism according to claim 5, wherein the first rotating shaft in the first damping structure is fastened to the first fastener.

7. The hinge mechanism according to claim 5 or 6, wherein the first fastener is slidably connected to the second fastener, so that the first fastener is capable of rotating about the first axis relative to the second fastener, and the first damping structure is capable of rotating relative to the second fastener under driving of the first fastener; and
the second damping structure is slidably connected to the second fastener, so that the second damping structure is capable of rotating about the second axis relative to the second fastener.

8. The hinge mechanism according to claim 7, wherein the second fastener comprises a base body extending in the second direction and two extension arms respectively connected to two ends of the base body in the second direction, each of the two extension arms extends in the first direction and protrudes from the base body toward a same side, so that mounting space is enclosed between the two extension arms and the base body, all of the first damping structure, the second damping structure, the connecting piece, and the first fastener are mounted in the mounting space, and in the first direction, the second damping structure is located on a side that is of the first damping structure and that is close to the base body, and the first fastener is located on a side that is of the first damping structure and that is away from the base body;
the first fastener comprises a base, a mounting portion, and two rotating arms, the base is fastened to the first component, the mounting portion is connected to the base, and protrudes from the base in the first direction toward a side on which the first damping structure is located, and the first rotating shaft in the first damping structure is mounted on the mounting portion;
the two rotating arms are respectively connected to two ends of the base in the second direction, the two rotating arms are in a one-to-one correspondence with the two extension arms of the second fastener, and each of the two rotating arms is slidably connected to a corresponding extension arm through a first sliding structure, so that the first fastener is capable of rotating about the first axis relative to the second fastener; and
the first sliding structure comprises an arc-shaped sliding groove and an arc-shaped slider that are slidably connected, one of the arc-shaped sliding groove and the arc-shaped slider in the first sliding structure is disposed on the rotating arm of the first fastener, and the other is disposed on the extension arm of the second fastener.

9. The hinge mechanism according to claim 8, wherein the mounting portion comprises two bosses spaced apart in the second direction, the first damping structure is located between the two bosses, a through-hole is disposed on each of the two bosses, and two ends of the first rotating shaft in the first damping structure protrude from the first sleeve, and respectively penetrate through the through-holes on the two bosses.

10. The hinge mechanism according to claim 8 or 9, wherein the first fastener further comprises a bump connected to the base, and the bump protrudes from the base in the first direction toward a side facing away from the first damping structure, and is built in the first component.

11. The hinge mechanism according to any one of claims 8 to 10, wherein the second damping structure further comprises two shaft sleeves spaced apart in the second direction, and the two shaft sleeves are respectively sleeved at two ends of the second rotating shaft; and the two shaft sleeves are in a one-to-one correspondence with the two extension arms of the second fastener, and each of the two shaft sleeves is slidably connected to a corresponding extension arm through a second sliding structure, so that the second damping structure is capable of rotating about the second axis relative to the second fastener; and
the second sliding structure comprises an arc-shaped slider and an arc-shaped sliding groove that are slidably connected to each other, one of the arc-shaped slider and the arc-shaped sliding groove in the second sliding structure is disposed on the shaft sleeve, and the other is disposed on the extension arm of the second fastener.

12. The hinge mechanism according to any one of claims 8 to 11, wherein the second fastener has two fastening portions, each of the two fastening portions comprises a first part extending in the second direction and a second part extending in the first direction, the first part and the second part are connected, the first parts of the two fastening portions are connected and fastened to form the base body of the second fastener, and the second parts of the two fastening portions respectively form the two extension arms of the second fastener.

13. An electronic device, comprising an electronic device body and a stand, and further comprising the hinge mechanism according to any one of claims 1 to 12, wherein one of the electronic device body and the stand is configured as a first component, and the other is configured as a second component, to rotatably connect the electronic device body and the stand through the hinge mechanism.

14. The electronic device according to claim 13, wherein the stand is configured as the first component, and the electronic device body is configured as the second component;
the electronic device body comprises a display screen, a middle frame, and a rear cover, the middle frame comprises a bottom plate and an outer frame, the display screen and the rear cover are respectively mounted at two ends of the outer frame in a third direction, and the bottom plate is located between the display screen and the rear cover, wherein the third direction is perpendicular to a first direction and perpendicular to a second direction;
a hollowed-out portion is disposed on the rear cover of the electronic device body, the hinge mechanism and the stand are arranged on the bottom plate of the middle frame in the first direction, and in the third direction, the stand and the hinge mechanism are correspondingly disposed in the hollowed-out portion on the rear cover;
the stand comprises a stand body and a mounting member, the stand body is set to be of a plate-like structure, the mounting member is connected to the stand body, and is located, in the third direction, on a side that is of the stand body and that faces the display screen, and the hinge mechanism is mounted on the mounting member of the stand, so that the stand is capable of rotating about a first axis relative to the electronic device body, to switch between a stowed state and an open state; and
when the stand is in the stowed state, the stand body is integrally built in the hollowed-out portion on the rear cover, or when the stand is in the open state, at least a partial structure of the stand body is separated from the hollowed-out portion and protrudes from an outer surface of the electronic device body.

15. The electronic device according to claim 14, wherein the electronic device body further comprises a cover plate, the cover plate is disposed in the hollowed-out portion on the rear cover, the cover plate is disposed, in the first direction, on a side that is of the stand and that faces the hinge mechanism, and is connected to the stand body, so that the cover plate and the stand form a stand structure, and when the stand is in the stowed state, a projection of the stand structure on the display screen in the third direction coincides with a projection of the hollowed-out portion on the display screen in the third direction;
a stepped structure is disposed on the bottom plate of the middle frame, the stepped structure is connected to the bottom plate, and is located, in the third direction, on a side that is of the bottom plate and that faces away from the display screen, the stepped structure comprises a top surface and a side surface that are perpendicular to each other, the side surface extends in the third direction, and the top surface is connected to an end that is of the side surface and that is away from the display screen in the third direction; and
when the stand is in the stowed state, the top surface is opposite to the stand body of the stand, or when the stand is in the open state, an opening is formed between the stand body and the top surface of the stepped structure.

16. The electronic device according to claim 15, wherein the first axis is located on a surface that is of the stand structure and that is away from the display screen in the third direction, and is located at a joint between the cover plate and the stand body.

17. The electronic device according to claim 15 or 16, wherein the mounting member of the stand is set to be of an arc-shaped structure, an accommodation groove is disposed in the mounting member, a partial structure of the hinge mechanism is located in the accommodation groove, and when the stand is in the stowed state, the mounting member is integrally located, in the first direction, on a side that is of the side surface of the stepped structure and that faces the cover plate, or when the stand is in the open state, at least a partial structure of the mounting member is located, in the first direction, on a side that is of the side surface of the stepped structure and that faces away from the cover plate.
